# EUROPÄISCHE PATENTSCHRIFT

(11) **EP 0 642 028 B1**
(45) Veröffentlichungstag und Bekanntmachung des Hinweises auf die Patenterteilung: **26.05.1999**
(21) Anmeldenummer: 94113567.5
(22) Anmeldetag: 31.08.1994
(51) Int. Cl.: G01R 31/28

(54) **Mess- und Experimentiersystem zur Erfassung und Bewertung des EMV-Verhaltens elektrischer Geräte, Baugruppen und Schaltungen**
Measuring and experimenting system for sensing EMP susceptibility of electrical appliances and circuits
Système de mesure et d'expérimentation pour déterminer le comportement électromagnétique d'appareils et circuits électriques

(30) Priorität: 08.09.1993 DE 4330345; 18.11.1993 DE 9317586 U; 27.11.1993 DE 4340514
(43) Veröffentlichungstag der Anmeldung: 08.03.1995
(73) Patentinhaber: Langer, Gunter, D-01728 Bannewitz (DE)
(72) Erfinder: Langer, Gunter, D-01728 Bannewitz (DE)
(74) Vertreter: Heyner, Klaus, Dr.-Ing.

(56) Entgegenhaltungen:
- DE-A- 2 533 984
- US-A- 4 071 780
- RADIO FERNSEHEN ELEKTRONIK, Bd.42, Nr.6, Juni 1993, BERLIN,DE Seiten 54 - 55, XP000394142 DIETHARD 'Messungen fur das CE-Zeichen'

## Beschreibung

Die Erfindung bezieht sich auf die gerätetechnische Ausstattung eines Meß- und Experimentiersystems, das für Modelluntersuchungen zum EMV-Verhalten aber auch zur Erfassung und Bewertung des EMV-Verhaltens elektrischer Geräte, Baugruppen oder einer elektronischen Schaltung eingesetzt werden kann.
Unter EMV-Verhalten soll dabei die geräteinterne Wandlung einer elektromagnetischen Störgröße in einen Funktionsfehler verstanden werden.

Mit dem neuen Meß- und Experimentiersystem soll am Modell aber auch an elektronischen Geräten bzw. Geräteteilen nachvollzogen bzw. ermittelt werden, ob eine elektromagnetische Störgröße das Gerät, die Schaltung beeinflussen kann oder nicht, ob eine evtl. Störgröße kritische Werte erreicht, erreichen kann oder nicht.

Der für die Störgröße ursächliche Störstrom wird meist über Leitungen an das Gerät herangeführt und dringt über die Geräteschnittstellen ein. Am leichtesten gelangt er über galvanische Verbindungen ins Geräteinnere. Ausreichend sind auch wenige Pikofarad parasitäre Koppelkapazität galvanisch trennender Schnittstellen (Relais, Übertrager, Optokoppler). Über parasitäre Gehäusekapazitäten kann der Störstrom ebenso fließen, wie über Kabelschirmkapazitäten.

Nur schwer zu beherrschende Verhältnisse liegen vor, wenn der Störstrom iₛₜ die Schaltungsmasse (GND) durchfließt und an ihrer verteilten Induktivität eine Längsspannung erzeugt. Diese wird von den Masseanschlüssen integrierter Schaltungen abgegriffen, gelangt an Schaltkreiseingänge E und wird, wenn die statische beziehungsweise dynamische Schaltschwelle eines IC überschritten wird, in ein Störsignal gewandelt. Das Störsignal kann über logische Wege zur Fehlfunktion des Gerätes führen.

Die Empfindlichkeit eines ICs ist von der Charakteristik seiner dynamischen Schaltschwelle abhängig.

Aus dem Stand der Technik bekannte Meßvorrichtungen, wie Oszilloskope und Spektrumanalysatoren messen den Zeitverlauf oder das exakte Amplitudendichtespektrum der Störvorgänge. Die dabei auftretenden Probleme können wie folgt zusammengefaßt werden.

Falls im Geräteinneren gemessen wird, werden die elektromagnetischen Geräteeigeschaften berücksichtigt. Jedoch fließt über die Meßleitungen zusätzlich ein Störstrom, der die Verhältnisse im Gerät verfälscht. Das elektromagnetische Verhalten des Gerätes verändert sich durch diese zusätzliche (metallische) Verbindung, was zu nicht zu vernachlässigenden Meßfehlern führt.

Ubliche, analogarbeitende Meßgeräte, wie selektive Nahfeld-Prüfsonden zur Lokalisierung dominanter Störstrahlungsquellen messen zwar die Störgrößen von außerhalb, eine Umrechnung auf die für logische Schaltfehler ausschlaggebende innere Störspannung Δ Ui am Eingang des ICs ist aber nur schwer und mit hohem Aufwand möglich.

Eine Berücksichtigung der elektromagnetischen Eigenschaften Integrierter Schaltkreise (IC) erfolgt durch die bekannte Meßtechnik nicht.
Aus dem Zeitverlauf von Meßwerten läßt sich erfahrungsgemäß nur schwer die Entscheidung ableiten, ob ein Gerät gestört ist oder nicht.

Abgeleitet von diesem Stand der Technik ist es Aufgabe der Erfindung, ein direkt anzeigendes Meß- und Experimentiersystem zu entwickeln, daß mit seinen Gerätebausteinen und in seinen Meßparametern das EMV-Verhalten des Meßobjektes nachbildet und dadurch die Störgröße bzw. die Gerätestörschwelle möglichst exakt und ohne Rückwirkungen erfaßt und den Beeinflussungsfall, ggf. mit einer vorherigen Warnphase zuverlässig anzeigt.

Mit dem modularen Aufbau des Meß- und Experimentiersystems soll die Erlangung von EMV-Know How durch das Training an Modellen bzw. originalen Schaltungsteilen erreicht und im Verlauf des Schaltungs- bzw. Geräteentwurfs eine Nachbildung und damit Abschätzung des EMV-Verhaltens ermöglicht werden. Dadurch wird ein EMV-gerechter Geräte- und Schaltungsentwurf gewährleistet.

Darüberhinaus sollen mit dem neuen Meßsystem einmal zu hohe, den ordnungsgemäßen Betrieb des Gerätes, der Schaltung beeinflussende Störgrößen signalisiert und die Wirkung von Entstörmitteln, wie Filter, Trennrelais, Trennübertrager, Stoßspannungsbegrenzer und Schirmungsmaßnahmen oder auch anderer EMV-Maßnahmen in ihrer Betriebszuverlässigkeit überwacht werden. Zum anderen soll für die EMV-Dimensionierung ein Meßsystem zur Verfügung stehen, mit dem man EMV-Maßnahmen an Geräten, Baugruppen und Schaltungen oder an bestimmten Orten auftretende Störgrößen bewerten kann.

Eine erfindungsgemäße Lösung dieser Aufgabe ist im Patentanspruch 1 angegeben. Weiterbildungen der Erfindung sind in den Unteransprüchen gekennzeichnet.

Die Störgrößen können leitungsgebunden als Störstrom oder über das im Raum vorhandene elektromagnetische Feld in das Gerät eindringen.
Das leitungsgebundene Eindringen ist für die Entstehung von Störgrößen und Funktionsfehlern dominierend. Bei den meisten Geräten ist nur ein leitungsgebundenes Eindringen möglich. Selbst wenn Störgrößen über das im Raum wirkende Feld eindringen, fließen sie als Störstrom durch die Schaltungen hindurch und über Leitungsverbindungen ab und können im Inneren auf den Schaltungen oder an den Zuführungs-Leitungen erfaßt werden.

Das erfindungsgemäße Meß- und Experimentiersystem wird durch Module bzw. Modulbausteine realisiert, die durch ihre variable Kombination und ihre Einstellparameter dem EMV-Verhalten des Gerätes bzw. der Schaltung angepaßt werden. Bei Annäherung des Wertes der Störgröße an den Wert, der einem Funktionsfehler entspricht, oder bei Erreichen dieses kritischen Wertes wird vom Meßsystem ein Signal erzeugt. Damit verbunden signalisiert das Meßsystem das Überschreiten seiner durch Einstellparameter festgelegten Störschwelle, wonach weitere erforderliche Aktivitäten wie Veränderungen von geometrischer Anordnung und Einstellparameter initiiert werden können.

Das vom Meßsystem erzeugte Signal kann auch eine Warnung auslösen oder in einem informationsverarbeitenden System zum Schutz des betreffenden Objektes, wie Geräte, Baugruppen, Schaltungen weiter verarbeitet werden.

Als Module werden im Rahmen des erfindungsgemäßen Meß- und Experimentiersystems die folgenden Funktionsbausteine eingesetzt, die alle zielbezogen auf die Lösung der Aufgabe der Erfindung entwickelt wurden.

Das erfindungsgemäße Meß- und Experimentiersystem verarbeitet hauptsächlich impulsförmige Störgrößen, die einen besonders steilen Anstieg (ns) und kurze Impulsbreiten (ns) besitzen; dazu gehören Burstimpulse, die durch Schaltvorgänge entstehen.
Diese Impulse können ohne Probleme über galvanische Trennstellen an die Geräteschnittstelle gelangen und in das Gerät eindringen. Sie fließen über die parasitären Kapazitäten (einige pF) der galvanischen Trennstellen und weiter über induktivitätsarme Leitungen der Geräteschaltung.

Auf diesem Weg kann der Störstrom an den parasitären Induktivitäten der Masseleitung (GND) einen Störspannungsabfall Δ Uᵢ erzeugen, der ggf. über Signalleiterzüge vom IC abgegriffen wird. Diese Spannung wird als induktive Komponente bezeichnet.
Weiterhin kann der Störstrom ein Magnetfeld erzeugen, das in Schleifen, die von Signalleiterzügen und Masseleitungen bzw. von speziellen GND-Strukturen gebildet werden, Spannungen induziert. Diese Spannungen liegen ebenfalls an den IC-Eingängen an und werden als magnetische Komponente bezeichnet.
Darüberhinaus kann durch Störspannungsdifferenzen zum Signalleiterzug noch eine elektrische Komponente entstehen.
Alle drei Komponenten erzeugen an den IC-Eingängen eine Störspannung.

Die Burstimpulse werden von einem Burstgenerator erzeugt.
Der Aufbau des Burstgenerators/Zählers ist auf das Experimentieren mit EMV-Sensoren zugeschnitten. Er vereinigt die für das Impulsdichteverfahren notwendigen drei Einzelgeräte Burstgenerator, Optischer Empfänger und Frequenzzähler in einem Gerät.
Beim Impulsdichteverfahren nach der DE-A-42 24 858 erzeugt ein Burstgenerator während der Zykluszeit T eine Burstimpulsfolge steigender Amplitude. Diese Burstimpulsfolge wird in ein Gerät, eine Baugruppe oder Schaltung eingekoppelt.
Eine Signalleitung wird mit dem EMV-Sensor verbunden. Bei überschreiten der dynamischen Störschwelle gibt der Sensor ein Signal ab. Das Signal wird zur Entkopplung über einen Lichtwellenleiter (LWL) geführt und zählt einen Frequenzzähler einen Schritt weiter. Der Frequenzzähler kann nur diejenigen Impulse des Störgenerators zählen, die die Störschwelle der Schaltung überschreiten. Die Impulszahl ist der Störschwelle umgekehrt proportional.
Das Impulsdichteverfahren ermöglicht die unkomplizierte Erfassung von Verträglichkeitsänderungen in einer Meßzeit von etwa einer Sekunde.

Der Burstgenerator/Zähler besitzt eine Anzeigeeinheit zur Ausgabe des Zählwertes des Frequenzzählers und jeweils eine Schnittstelle zur Steuerung und Parameterverstellung des Burstgenerators und des Zählers und zur Zähldatenweitergabe. Der Burstgenerator/Zähler kann mit dem PC verbunden werden.
Der Burstgenerator besteht aus einem Kondensator C, der mit einem Hochspannungsimpuls der Frequenz f₁ periodisch aufgeladen wird.
Parallel zum Kondensator C befindet sich eine in ihrer Schlagweite s mit der Frequenz f2 veränderliche Funkenstrecke.

Jeder Hochspannungsimpuls bewirkt beim Erreichen der der Durchschlagspannung der Funkenstrecke entsprechenden Spannung am Kondensator C einen Durchschlag der Funkenstrecke und jeder Hochspannungsimpuls erzeugt mindestens einen Durchschlag.
Die Entladung der Funkenstrecke erfolgt über das Netzwerk R, das im einfachsten Fall aus einer R-L-Kombination oder auch nur aus einem Widerstand besteht. Mit diesem Netzwerk kann die Impulsform der Entladung beeinflußt werden. Die Entladung selbst wird als Störimpuls am Ausgang des
Generators ausgekoppelt. Die Auskopplung erfolgt dabei am Netzwerk R oder am Kondensator C.
Die Spannungsimpulserzeugung und die periodische Schlagweitenveränderung erfolgen vorzugsweise mit unterschiedlicher Frequenz. Generell kann jedoch die Funkenstrecke mit ihrer Frequenz f₂ synchron oder asysnchron zu den Hochspannungsimpulsen der Frequenz f₁ schwingen. Ein asynchrones Schwingen bewirkt jedoch eine größere Amplitudenvielfalt.

Der Vorgang besteht im Normalfall aus mehreren Perioden eines durch pendelnde oder rotierende Bewegung der Kontakte bewirkten öffnens und Schließens der Funkenstrecke.
Das pendelnde öffnen und Schließen kann durch ein schwingendes mechanisches System erzeugt werden, das hohe Schaltgeschwindigkeiten erreicht.
Der einzelne Impuls zündet dabei in das schwingende Kontaktsystem der Funkenstrecke hinein und findet hier eine jeweils unterschiedliche Schlagweite s(t) vor. Diese unterschiedliche Schlagweite führt wiederum zu der gewünschten unterschiedlichen Durchschlagspannung und damit zur Generierung einer für die Meßaufgabe erforderlichen Störamplitudenfolge.

Die rotierende Bewegung der Funkenstrecke kann durch einen kreisenden Kontakt erzeugt werden, der eine exzentrische Bewegung ausführt, beispielsweise mittels einer exzentrisch geformten Kurvenscheibe,

EMV-Sensoren dienen der Realisierung definierter IC-Empfindlichkeiten. Ihr Eingang ist ein IC-Eingang definierter Empfindlichkeit. Er wandelt die durch die drei Komponenten erzeugte Störspannung bei Störschwellenüberschreitung in ein optisches Signal. Das Signal wird vom optischen Empfänger und Frequenzzähler nach dem Impulsdichteverfahren ausgewertet. Die Erfassung von Burstmagnetfeldern erfolgt mit einer Induktionsschleife; die Induktionsschleife bildet einen Signalleiterzug in einer Schaltung nach. Die Schleife kann flexibel als Kabel oder als starre Schleife ausgeführt sein.

Diese mit dem EMV-Sensor gekoppelte Induktionschleife wird in das beim Stromfluß aufgebaute Magnetfeld der auszumessenden Geräte, Baugruppen und Schaltungen eingebracht.
Analog zur Induktionsschleife können auch Magnetfeldsonden eingesetzt werden. In der Grundkonfiguration besteht eine derartige Magnetfeldsonde aus einer Induktionsschleife, einem optischem Sender und einem Lichtwellenleiter. Zum Betreiben der Sonde ist keine Hilfsenergie erforderlich.

Bei einer speziellen Ausführung der Sonde ist zur Erhöhung und zur Regulierung der Empfindlichkeit eine Konstantstromquelle vorhanden, wodurch die statische und dynamische Schaltschwelle des optischen Senders gesenkt werden kann. Der optische Sender besteht im einfachsten Fall aus einer Sendediode. Der Konstantstrom wird in der Sendediode dem Strom der Induktionsschleife überlagert. Die Empfindlichkeit kann an einem Einstellregler verändert werden.

Die Induktionsschleife ist austauschbar gegen Schleifen anderer Parameter (Durchmesser, Windungszahl).

Zur Impulsverlängerung können schnelle Dioden in Verbindung mit Kondensatoren und Widerständen verwendet werden. Als schnelle Diode kann parallel oder in Reihe zum optischen Sender ein Stoßspannungsbegrenzer vorgesehen werden.
Die Sonde erfaßt Burstmagnetfelder hoher Flankensteilheit und wurde für die Anwendung des Impulsdichteverfahrens konzipiert.

Weiterhin kann die Induktionsschleife zur Erzeugung von Magnetfeldern mit dem Burstgenerator verbunden werden.

Zur Nachbildung bestimmter Beeinflussungsfälle bzw. Anpassung an die Eigenschaften bestimmter im Entwurfsstadium befindlicher, zu testender bzw. überhaupt auf EMV-Verhalten zu untersuchender Schaltungen und Geräte werden spezielle Schaltungsmodelle eingesetzt.
Das Schaltungsmodell U dient einfachen Untersuchungen der elektrischen und magnetischen Beeinflussungskomponenten.
Als Einkoppelstrukturen lassen sich Leitungen oder eine Induktionsschleife anschließen.

Ein zweites Schaltungsmodell M dient der Untersuchung magnetisch wirksamer Öffnungen in GND-Flächen; es besitzt einen Signalleiterzug. Zur Abdeckung der im Schaltungsmodell befindlichen Öffnung sind zwei GND-Flächen bestimmter Größe (nach vorgegebener Geometrie) erforderlich.

Ein drittes Schaltungsmodell K ist für universelle Untersuchungen der elektrischen, magnetischen und induktiven Beeinflussungskomponenten und der EMV-Eigenschaften von IC vorgesehen. Im Modell ist eine Signalverbindung zwischen zwei IC nachgebildet. Es lassen sich IC mit bestimmten Eingangs- und Ausgangseigenschaften auf Fassungen aufstecken. Ein EMV-Sensor kann direkt an die Signalverbindung oder durch Zwischenschalten eines IC angeschaltet werden. Die GND-Verhältnisse sind durch Einschieben spezieller GND-Flächen veränderbar.
Auf der Signalverbindung können bestimmte logische Pegel über Steckbrücken oder durch Aufstecken eines Signalgenerators erzeugt werden.

GND-Flächen unterschiedlicher Geometrie stehen als Module zur Verfügung. Sie sind insbesonder zum Einschieben in das speziell dafür vorgesehene Schaltungsmodell K konzipiert. Auf den Flächen sind bestimmte geometrische GND-Strukturen realisiert. Die Flächen verändern je nach Flächenart, Kombination und Einschiebetiefe die GND-Verhältnisse des Schaltungsmodells.

Das Schaltungsmodell G 01 dient der universellen Untersuchung von Beeinflussungsproblemen, die bei der Verbindung von Baugruppen auftreten. Das Schaltungsmodell G 02 ist das dafür entwickelte Gegenstück (Leitungsverbindung). Für den Zweck besitzen die Schaltungsmodelle G 01 als Schaltungszentrum einen ähnlichen Aufbau wie das Modell K. Im Modell ist eine Signalverbindung zwischen zwei IC nachgebildet. Es lassen sich IC mit bestimmten Eingangs- und Ausgangseigenschaften auf Fassungen aufstecken. Ein EMV-Sensor kann direkt oder über einen IC angeschaltet werden. Die GND-Verhältnisse sind durch Einschieben spezieller GND-Flächen veränderbar.

Die Verbindung zu einer "anderen Baugruppe", d.h. im Modellfall zu einem anderen Schaltungsmodell (G02), zu einem Anwendermodell oder zu einer Anwenderbaugruppe kann über die Pfostenleiste und eine Leitung erfolgen. Die Pfostenleiste ist über Signalleiterzüge mit den Ausgängen oder Eingängen eines IC verbindbar. Steckbrücken dienen bei allen Schaltungsmodellen der Veränderung der GND und Vcc Belegung der Leitung. Mit einem Referenz-IC kann die über die Leitung erzeugte Beeinflussung verglichen werden.
Steckbrücken dienen auch der Verbindung des IC und Referenz-IC mit dem Schaltungszentrum.

Das Schaltungsmodell G 02 dient vergleichenden Untersuchungen zum Problemkreis der Eingangsbeeinflussung von Geräten, Baugruppen und integrierten Schaltungen (IC). Es kann separat oder mit dem Schaltungsmodell G 01 bzw. Anwendermodellen als Zweibaugruppensystem benutzt werden. Auf dem Modell befindet sich eine Steckfassung für IC. Die IC-Eingänge sind über Steckbrücken und einer Pfostenleiste mit einer Leitung verbindbar. Über die Leitung kann eine Verbindung mit Anwendermodellen oder mit den Schaltungsmodellen G 01 hergestellt werden.

Ein weiteres Schaltungsmodell I dient der Realisierung der induktiven Beeinflussungskomponente. Es besitzt einen ausgeprägten GND-Leiterzug, in den Störstrom eingespeist werden kann. Mit einem Signalleiterzug können Längsspannungen auf dem GND-Leiter abgegriffen werden. Der Abgriff ist durch einen Schleifer verstellbar.
Die Längsspannungen werden an den Eingang eines EMV-Sensors oder zwischengeschalteten IC geführt.

Das Schaltungsmodell R dient der Untersuchung von Störgrößen und Beeinflussungsvorgängen, die durch schaltende Kontakte hervorgerufen werden.
Auf das Schaltungsmodell R sind Schaltkontakte, Schalter oder Relais aufsteckbar. Das Kontaktsystem der Schaltkontakte, Schalter oder Relais schaltet eine über Versorgungsschienen geführte Steuerspannung auf eine Lastleitung. Die Versorgungschiene besteht aus spannungsführendem Leiter und Rückleiter. An den beiden Enden der Versorgungschiene befinden sich Verbindungs- und Beschaltungsfelder (VBF), die auf der einen Seite eine Verbindung zur Zuführung der Steuerspannung herstellen und auf der anderen Seite eine Verbindung zum Relais und der Last.
Der Steuerstromkreis ist in den VBF mit Entstörbauelementen beschaltbar.
Die für den Steuerstromkreis aktiven Versorgungsschienen (spannungsführender Leiter und Rückleiter) können in ihrem Abstand variiert werden.
Die vom Schaltungsmodell R erzeugten Störgrößen und Beeinflussungsvorgänge werden zur Beaufschlagung anderer Teile des Meß- und Experimentiersystems genutzt.

Zur EMV-Dimensionierung von Signaleingängen an Schnittstellen ist das Schnittstellenmodell SM vorgesehen. Es lassen sich Schnittstellenschaltungen durch Aufstecken von Bauelementen (Trans-Zorb, Varistoren, Kondensatoren, Widerstände, usw.) oder durch Zuschalten interner Bauelemente über DIL-Schalter realisieren. Die erforderliche IC-Empfindlichkeit ist durch Aufstecken entsprechender EMV-Sensoren oder spezieller Bauelemente (IC, Optokoppler, usw.) auf einen IC-Adapter (bis 16polig) einstellbar.

Alle Schaltungsmodelle können mit einem speziellen Stromversorgungsbaustein SV verbunden werden. Er dient der galvanisch getrennten 5 Volt Spannungs-Versorgung von EMV-Sensoren und IC. Diese können sich auf dem Stromversorgungsbaustein oder auf Schaltungsmodellen befinden. Die Verbindung mit einem Schaltungsmodell erfolgt über einen direkten Steckverbinder. Über ihn werden die GND-Flächen, die bei Anschluß des Sensors auf dem Stromversorgungsbaustein erforderlichen Sensoreingänge und die Verbindungen für die Spannungsversorgung geführt.

Als weiteres Modul für das erfindungsgemäße Meß- und Experimentiersystem steht ein quarzstabilisierter Signalgenerator SQ zur Verfügung. Er ist zum Aufstecken auf den beschriebenen Schaltungsmodellen vorgesehen und dient der Einspeisung logischer Signale. Der Signalgenerator ist störfest aufgebaut und verändert durch seine Kleinheit die elektromagnetischen Verhältnisse auf den Schaltungsmodellen auch für schnelle Vorgänge nur wenig. Seine Frequenz ist in Stufen verstellbar.

In einem PC kann parallel zur Zählfunktion des Zählers im Burstgenerator/Zähler die zum Impulsdichteverfahren zugehörige Zählung und Auswertung der vom Sensor abgegebenen Impulse ausgeführt werden.
Das PC-Modul übernimmt dabei die Verbindung zum PC. Das PC-Modul kann die Sensorsignale vorverarbeiten und den PC mit speziellen logischen Strukturen bezüglich der Echtzeitverarbeitung aller aufzunehmenden und abzugebenden Signale unterstützen.
Die Lichtwellenleiter der EMV-Sensoren werden zum PC-Modul geführt; die Signale werden von optischen Empfängern aufgenommen, vorverarbeitet und über das PC-Modul an den PC übertragen.

Der Burstgenerator kann über das PC-Modul hinsichtlich der Ein-Aus-Schaltung und im Sinne einer Parameterverstellung gesteuert werden.
Schaltungsmodelle bzw. Prüflinge können durch den PC über das PC-Modul gesteuert werden. Dafür sind spezielle optoelektrische Wandler vorgesehen, die Lichtsignale in elektrische Signale wandeln. Diese Wandler werden auf dem Schaltungsmodell bzw. Prüfling angeordnet.
Im Wandler wird das Lichtsignal in ein äquivalentes digitales elektrisches Signal gewandelt und dem Signalausgang über einen Treiber zugeführt. Der Signalausgang ist umschaltbar zwischen offenem Kollektor und TTL-Ausgang. Eine LED-Anzeige signalisiert den aktiven bzw. inaktiven Zustand des Signalausgangs.

Der optoelektrische Wandler kann durch ein Relaismodul ergänzt werden. Es dient zum Schalten von Lastströmen z.B. der Stromversorgung von Schaltungsmodellen oder elektronischen Baugruppen und Geräten.

Als EMV-Sensor zur Bewertung von Störgrößen an einem bestimmten Ort und der störgrößenabschwächenden Wirkung von EMV-Maßnahmen wird erfindungsgemäß ein neuer Kabel- und Gerätesensor eingesetzt.
Dieser Kabel- und Gerätesensor läßt sich auf Schaltungsmodellen oder in elektronischen Geräten analog dem EMV-Sensor oder einem Sensor mit vorgeschaltetem IC einsetzen.
Er besitzt ebenfalls einen Eingang mit definierter Empfindlichkeit.

Die Störschwelle kann am Sensor über zwei Meßparameter, die Kopplung und die IC-Empfindlichkeit, eingestellt werden.
Die Kopplung charakterisiert die Eindringfähigkeit von impulsartigen Störgrößen von den Geräteschnittstellen bis zu den IC-Eingängen.

Die Festigkeit der hardware elektronischer Geräte oder Baugruppen gegenüber elektromagnetischen Störgrößen wird als physische Robustheit bezeichnet. Dabei umfaßt der Begriff "physische Robustheit" den Wirkungsweg der Störgröße vom Eintritt in das Gerät bzw. die Baugruppe bis zur Wandlung in eine logische Veränderung.
Dieser Wirkungsweg unterteilt sich in zwei Wegabschnitte, die geometrische Komponente der physischen Robustheit und in die Komponente der IC-Empfindlichkeit. Die geometrische Komponente umfaßt den Bereich vom Eintritt der Störgröße in die Geräteschaltung bis hin zur Wandlung in eine an einem IC-Eingang anliegende Störspannung. Dieser Wandlungsweg ist hauptsächlich von der Geometrie der leitfähigen Teile der Hardwareanordnung abhängig und wird deshalb als geometrische Komponente bezeichnet.

Der Störstromweg, der durch seine geometrischen und elektrischen Eigenschaften die Höhe und den Verlauf des Störstromes bestimmt, verläuft oft nicht nur in der Geräteschaltung (geometrische Komponente der physischen Robustheit). Bevor er in die Geräteschaltung eindringt, fließt er über Geräteschnittstellen, Kabel, Gehäuse- oder Konstruktionsteile (Geräteschnittstellen zur Umgebung).
Dieser gesamte Weg läßt sich als erster Einstellparameter definieren. Er wird als Kopplung bezeichnet.

Der zweite Wegabschnitt, die IC-Empfindlichkeit, wird durch die Wandlung der am IC-Eingang anstehenden Störspannung in ein logisches Signal charakterisiert. Dabei wandelt ein logisches Element des IC die an einem Eingang anstehende Störspannung in ein logisches Ausgangssignal.
Die Kenngröße Empfindlichkeit beinhaltet die Wandlungsfähigkeit einer Störspannung in ein logisches Signal durch ein logisches Element. Das logische Signal kann in der logischen Struktur der Schaltung weiterverarbeitet werden und letztlich zu Funktionsfehlern führen. An den Wirkungsweg des Störvorganges, der durch die physische Robustheit beschrieben wird, schließt sich der Wirkungsweg der logischen Robustheit an. Die logische Robustheit verhindert mit logischen Mitteln, daß das über die physische Robustheit vermittelte Störsignal (logisches Signal) sich in Funktionsfehler wandelt.

Die IC-Empfindlichkeit stellt im Sinne der Auswertung der dynamischen und statischen Schaltschwelle den zweiten Parameter für die Beschreibung der EMV-Eigenschaften elektronischer Geräte, Baugruppen oder Schaltungen dar.

Der erste Sensorparameter wird technisch realisiert durch eine Erfassungseinheit der Störgröße, die die Geometrie der Schaltung bzw. die elektromagnetischen Geräteeigenschaften nachbildet. Diese Erfassungseinheit wirkt zusammen mit einer Baugruppe, die die Verstellbarkeit der elektromagnetischen Eigenschaften gewährleistet.

Die Erfassungseinheit besteht aus der Induktionschleife, die die Form einer einfachen Induktionsschleife oder die Form einer Acht aufweist. Dabei wirkt die Schleife wie ein Signalleiterzug einer Schaltung.
Die Schleife kann alternativ in einem kompakt ausgeführten Kabel- und Gerätesensor fest eingebaut sein. Sie kann über Steckverbinder von außen aufsteckbar sein (Modul), oder über Steckverbinder kann der Kabel- und Gerätesensor mit geräteinternen Leiterschleifen (Leiterkarte des Prüflings) verbunden werden.

Anstelle der Induktionsschleife kann ein elektrisch leitfähiges Plattenpaar zur Erfassung der elektrischen Komponente verwendet werden. Dabei kann das Plattenpaar analog einem Plattenkondensator aufgebaut sein. Die Platten können aber auch in gestreckter bzw. linienförmiger Ausführung in einer Ebene nebeneinander oder hintereinander angeordnet sein. Jeder der beiden Anschlüsse, die für die Induktionsschleife vorgesehen sind, werden mit je einer Platte des Plattenkondensators verbunden. Der Plattenkondensator erfaßt eine Spannungsdifferenz bzw. einen Verschiebestrom des elektrischen Störfeldes.
Eine Platte des Kondensators kann von den leitfähigen Teilen des Gerätes der Baugruppe oder der Schaltung gebildet werden.
Der Plattenkondensator kann intern oder extern über Steckverbinder an den Kabel- und Gerätesensor angeschlossen sein.

Als Baugruppe zur Verstellung der elektromagnetischen Geräteeigenschaften dient ein Spannungsteiler R1.

Der zweite Sensorparameter wird realisiert durch eine Einheit zur Berücksichtigung bzw. Nachbildung der IC-Empfindlichkeit.
Die IC-Empfindlichkeitsverstellung erfolgt durch solche Maßnahmen, wie Verringerung der statischen und dynamischen Schaltschwelle durch Potentialanhebung bzw. Stromüberlagerung oder Erhöhung der dynamischen Schaltschwelle durch Tiefpaßeinsatz.

In einer anderen Ausführungsform kann der Kabel- und Gerätesensor auch nur mit einer Verstellmöglichkeit bei konstanter IC-Empfindlichkeit ausgebildet sein.

Die Empfindlichkeit des Meßsensors kann beispielsweise durch IC-Steckmodule, die unterschiedliche Empfindlichkeit besitzen, in diskreten Schritten variiert werden. Diese Form der Empfindlichkeitsverstellung kann zusätzlich zur kontinuierlichen IC-Empfindlichkeitsverstellung erfolgen.

Zur besseren Auswertung der gemessenen Sensorparameter wird der Einheit für den zweiten Sensorparameter, die mit der Erfassungseinheit für den ersten Sensorparameter in Reihe geschaltet ist und ein logisches Signal S abgibt, eine Impulsformer-/Treiberstufe sowie eine Anzeige- und/oder Verarbeitungs- und Ausgabeeinheit nachgeschaltet.

Als Anzeige- und/oder Ausgabeinheit werden parallel oder alternativ eingesetzt eine LED-Anzeige, ein akustischer Signalgeber, ein potentialfreier Ausgang (Relais) für langsame Anzeigevorgänge, optische Sender mit Lichtwellenleiteranschluß, Optokoppler, Transistorausgang sowie spezifische Datentreiber für schnelle Ausgaben.

Wesentliche Vorteile des Kabel- und Gerätesensors sind die eigene Stromversorgung, die Verstellbarkeit der Empfindlichkeit und Kopplung, eine eigene Anzeige (LED, akustisches Signal), die Einstellbarkeit einer Grundempfindlichkeit durch Aufstecken von IC mit definierter Empfindlichkeit, LWL-Anschluß, die Möglichkeit der unterbrechungsfreien Stromversorgung durch interne Batterien, die Ausbildung intern zuschaltbarer Signalleiterzüge als Induktionsschleife oder die Ausbildung als Kondensatorplatte. Hervorzuheben sind auch extern anschließbare Signalleitungen, die als Referenzsignalleitung mit definierter Morphologie, als beliebige Schleifen oder Platten oder als prüflingsinterne Signalleitungen ausgeführt sind.

Der Kabel- und Gerätesensor eröffnet darüberhinaus ein neues Anwendungsgebiet bei der Erfassung von leitungs-oder feldgebundenen Störemissionen elektronischer Schaltungen.
Die Anwendung kann an Schaltungsmodellen des Meß- und Experimentiersystems oder auch an originalen Geräten oder Schaltungen erfolgen. Vorzugsweise wird für diesen Anwendungsfall der Sensor mit einer zusätzlichen Verstellmöglichkeit der Empfindlichkeit ausgerüstet, die eine lupenartige Feineinstellung ermöglicht.

Als Erfassungseinheit können die bereits beschriebenen Einrichtungen, wie eine Induktionsspule für die Erfassung von Magnetfeldern, oder ein leitfähiges Platten- oder Stabpaar für die Erfassung von elektrischen Feldern verwendet werden. Das Plattenpaar ist vorzugsweise in gestreckter Ausführung hintereinander angeordnet. Die Erfassung einer induktiven Komponente kann durch Abgriff auf Kabel, Leitungen, Leiterzügen oder metallischen Konstruktionsteilen erfolgen.

Mit dem Kabel- und Gerätesensor wird über die Erfasungseinheit das leitungsgebundene oder abgestrahlte Feld aufgenommen und mit der am Sensor eingestellten Kopplung und Empfindlichkeit bewertet. Bei Überschreitung der eingestellten Störschwelle erfolgt der bereits beschriebene Funktionsablauf.

Weitere Einzelheiten, Merkmale und Vorteile der Erfindung ergeben sich aus der nachfolgenden Beschreibung von Ausführungsbeispielen.

In der zugehörigen Zeichnung zeigen
- Fig. 1: die Gesamtansicht des Burstgenerators/Zählers,
- Fig. 2: den prinzipiellen Aufbau des Störgenerators,
- Fig. 3: eine Schaltungsvariante des Störgenerators,
- Fig. 4: die Induktionsschleife, als Modul ausgeführt,
- Fig. 5: Magnetfeldsonden mit Angabe der möglichen Schaltungen,
- Fig. 6: eine Ausführung des Schaltungsmodells U,
- Fig. 7: eine Ausführung des Schaltungsmodells M,
- Fig. 8: eine Ausführung des Schaltungsmodells K,
- Fig. 9: eine Ausführung der Schaltungsmodelle G01 und G02,
- Fig. 10: eine Ausführung des Schaltungsmodells I,
- Fig. 11: eine Auswahl geometrischer Gestaltungsvarianten für GND-Flächen,
- Fig. 12: eine Ausführung des Schaltungsmodells R,
- Fig. 13: eine Ausführungsform des Schnittstellenmodells SM,
- Fig. 14: den Stromversorgungsbaustein SV,
- Fig. 15: die schematische Darstellung eines Signalgenerators SQ,
- Fig. 16: Blockschaltbild des Kabel- und Gerätesensors,
- Fig. 17: Blockschaltbild des Meßsensors mit Angabe aller Baugruppen,
- Fig. 18: ausgeführte Schaltung auf der Grundlage des Blockschaltbildes nach Fig. 17.

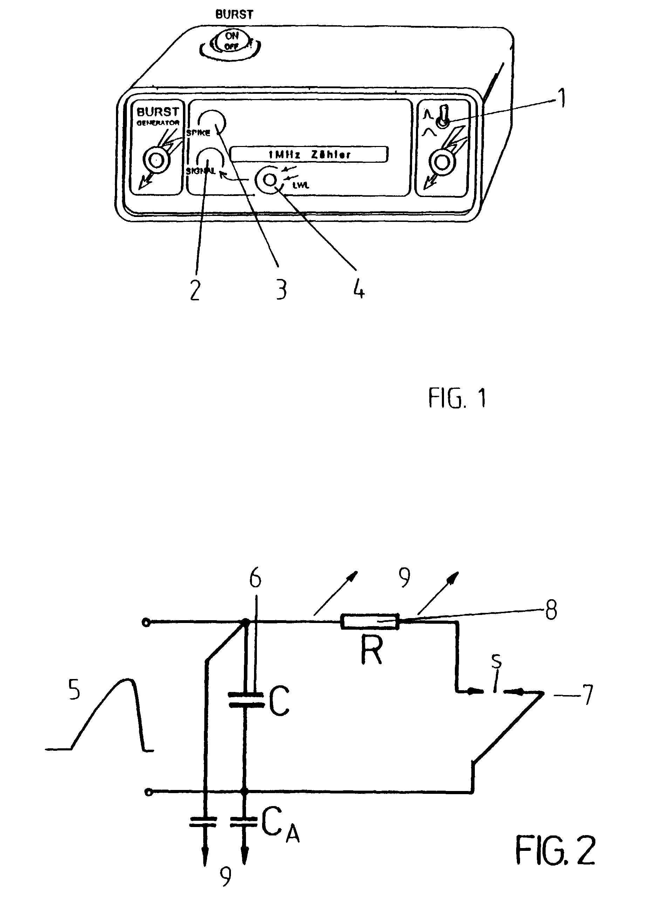

Der Burstgenerator in Fig. 1 erzeugt kontinuierlich Burstimpulse unterschiedlicher Amplitude. Die Höhe der Amplitude ist statistisch gleichmäßig verteilt. Mit einem Schalter 1 ist die Steilheit der Burstimpulse umschaltbar.

Der Optische Empfänger ist mittels Anschluß 4 über 2,2 mm Plast- Lichtwellenleiter mit einem EMV-Sensor verbunden.
Das empfangene Signal wird an der LED SIGNAL 2 angezeigt.
Zu kurze und deshalb nicht sichtbare Impulse werden gedehnt und sind an der LED SPIKE 3 erkennbar. Der Optische Empfänger ist intern mit dem Frequenzzähler verbunden.

Der Frequenzzähler erfaßt die Burstimpulse, die die Störschwelle des Sensors in der Meßanordnung überschreiten und als Lichtsignal den Optischen Empfänger erreichen. Je niedriger die Störschwelle liegt, um so mehr Zählimpulse werden erzeugt, und um so höher ist das Zählergebnis. Der Zahlenwert ist umgekehrt proportional der elektromagnetischen Verträglichkeit der Meßanordnung.
Die Hilfsenergie wird mittels Steckernetzteil 12 Volt DC, 800 mA bereitgestellt, die Anzeige ist 6-stellig, Meßzeit und Meßzyklus betragen 1 Sekunde.

Fig. 2 veranschaulicht den prinzipiellen Aufbau des erfindungsgemäßen Störgenerators. Parallel zu einem mit Hochspannungsimpulsen 5 der Frequenz f₁ aufgeladenen Kondensator 6 ist eine in ihrer Schlagweite s nach der Frequenz f2 veränderliche Funkenstrecke 7 angeordnet. Die Auskopplung der Störimpulse 9 erfolgt entweder am Kondensator 6 mittels der Auskoppelkondensatoren C_{A} oder über den Widerstand bzw. das Netzwerk 8.

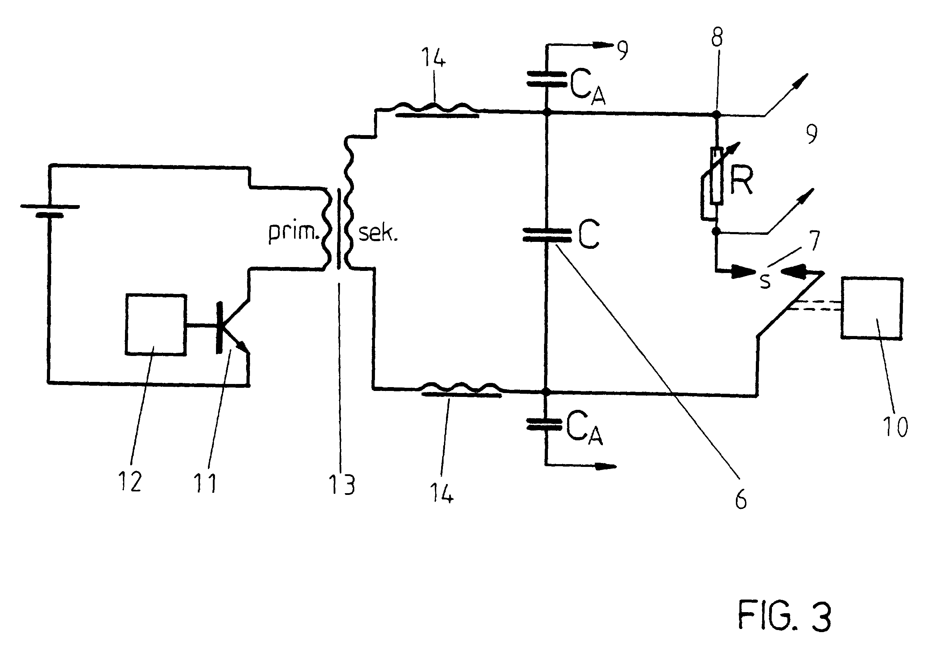

Fig. 3 zeigt eine Ausführungsvariante für die Schaltung des neuen Störgenerators. Bei der Zündschaltung für die Erzeugung der Hochspannungsimpulse wird der Transistorunterbrecher 11 von einem Frequenzgenerator 12 mit der Frequenz f₁ angesteuert. Der Transistorunterbrecher 11 unterbricht einen Gleichstrom in der Primärwicklung des Transformators 13, wodurch ein Spannungsimpuls auf der Sekundärseite des Trafos 13 induziert wird.
Dieser Spannungsimpuls lädt über die Drosseln 14 den Kondensator 6 auf. Wenn die Spannung am Kondensator C der Durchschlagspannung der Funkenstrecke 7 entspricht, wird infolge des Durchschlagens der Funkenstrecke der Kondensator C schlagartig entladen. Mit den Drosseln 14 wird der Vorgang vom Trafo 13 entkoppelt. Die Steilheit des Entladevorganges von C wird vom Netzwerk 8, hier ein Widerstand R, bestimmt. Diese steile Spannungsflanke wird als Störimpuls aus der Schaltung ausgekoppelt. Die Auskopplung 9 kann über die Auskoppelkondensatoren C_{A} am Kondensator C erfolgen oder direkt am Widerstand R.

Um die für die Anwendung des Impulsdichteverfahrens erforderliche homogene Verteilung der Störimpulsamplituden zu erreichen, wird die Schlagweite der Funkenstrecke s kontinuierlich vergrößert bzw. verringert. Dieser Vorgang erfolgt periodisch mit der Frequenz f₂. Dazu wird ein mechanisch pendelndes bzw. schwingendes System verwendet, was im einfachsten Fall durch das Kontaktsystem eines Relais realisierbar ist. Das Relais wird vom Frequenzgenerator 6 mit der Frequenz f₂ periodisch erregt.
Die Frequenz f₁ des Generators 12 ist höher als die Frequenz f₂ des Generators 10 eingestellt.
Beide Generatoren 12, 10 laufen asynchron, so daß die Amplituden der Impulsfolgen quasi statistisch verteilt sind.

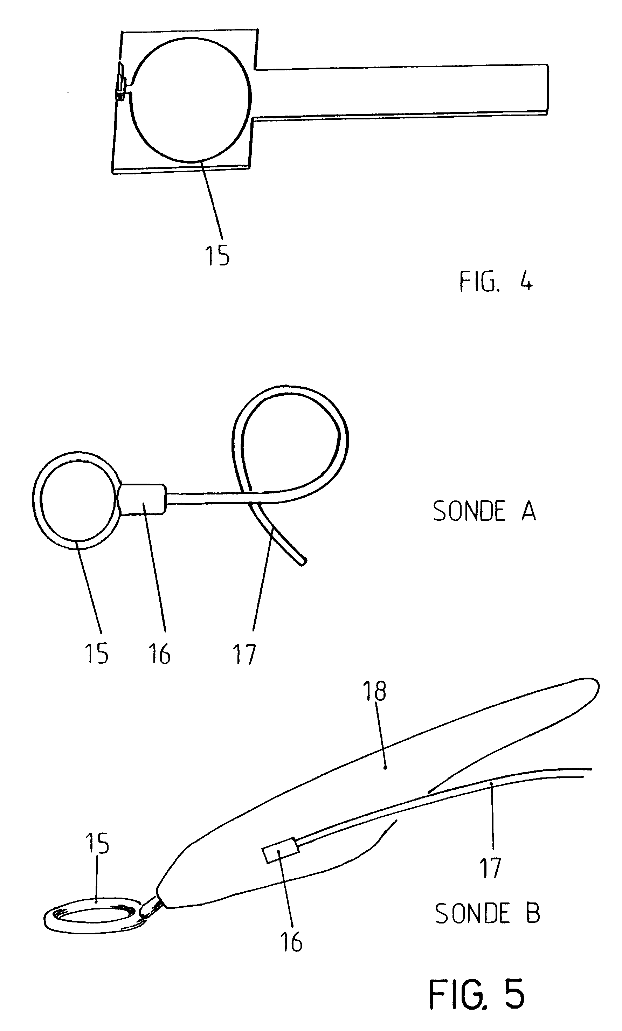

Die in Fig. 4 dargestellte Induktionsschleife 15 dient der Untersuchung der magnetischen Komponente in Schaltungen und Schaltungsmodellen. Die Schleife wird über zwei Kabel (0,64 mm Buchse) mit dem Schaltungsmodell bzw. einem EMV-Sensor verbunden.

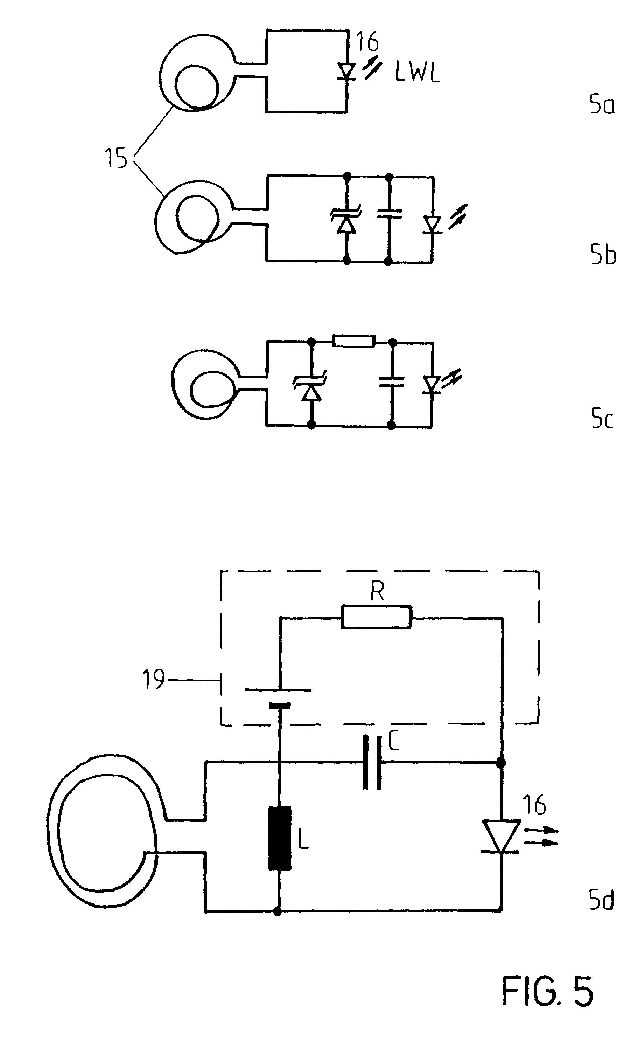

Fig. 5 zeigt die analog zur Induktionsschleife einzusetzenden Magnetfeldsonden in der einfachen Ausführung gemäß Sonde A und in der komfortableren Ausführung gemäß Sonde B mit Griff (Gehäuse) 18. Zwischen der Induktionsschleife 15, deren Größe an die konkrete Meßgeometrie anpaßbar ist, und dem Griff bzw. Gehäuse 18 ist eine Steckverbindung vorgesehen. Die Sonden A und B sind aus einer Induktionsschleife 15, einem optischen Sender 16, der hier lediglich aus einer Sendediode besteht (s. Fig. 5a), und einem Plastlichtwellenleiter 17 aufgebaut.
Der Lichtwellenleiter 17 der Sonde wird mit dem optischen Empfänger des Burstgenerators/Zählers verbunden. Der Zähler des Gerätes ermittelt die Impulsdichte des von der Sonde aufgenommenen Magnetfeldes. Der Störstrom zum Aufbau eines entsprechenden Magnetfeldes wird vom Burstgenerator erzeugt.
In der angegebenen Schaltung nach 5b und 5c ist als Stoßspannungsbegrenzer eine schnelle Diode (Trans-Zorb) parallel geschaltet.

Der Schaltung 5 a, b, c wird ein Konstantstrom aus der Konstantstromquelle 19 überlagert. Dadurch erhöht sich die Empfindlichkeit der Sendediode 16 gegenüber pulsartigen Strömen der Induktionsschleife 15. Zur Impulsentkopplung wird zwischen Konstantstromquelle 19 und Impulsstromkreis eine Drossel L angeordnet. Der Konstantstrom wird durch einen Kondensator C von der Induktionsspule entkoppelt.
Die Konstantstromquelle 19 besteht im einfachsten Fall aus einer Batterie mit einem Vorwiderstand. Der Vorwiderstand kann zur Einstellung verschiedener Ströme und damit Empfindlicheiten verstellbar sein.

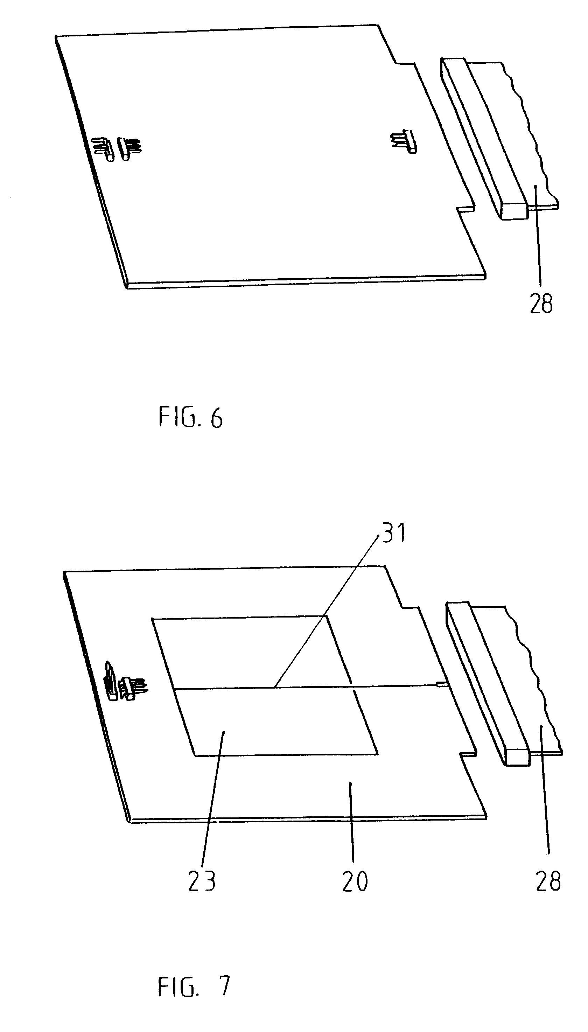

Die Figuren 6 bis 10 zeigen Ausführungsvarianten von Schaltungsmodellen. Das Schaltungsmodell U nach Fig. 6 ist für einfache Untersuchungen der elektrischen und magnetischen Beeinflussungskomponenten vorgesehen. Als Einkoppelstrukturen werden Leitungen mit 0,64 mm Buchse oder eine Induktionsschleife 15 angeschlossen.

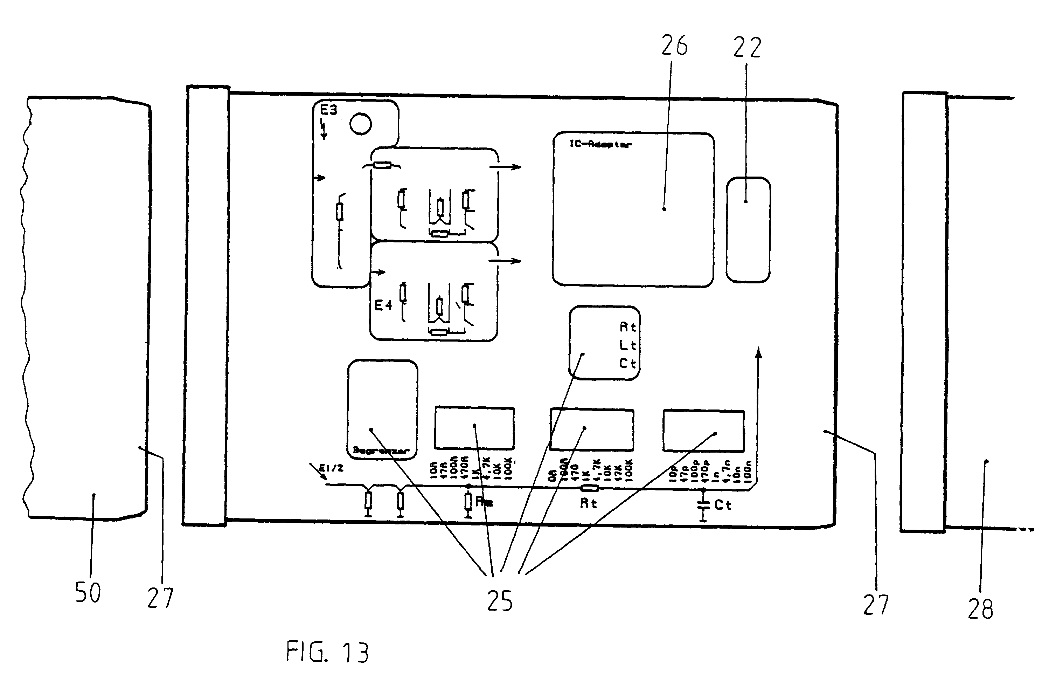

Die Stromversorgung erfolgt für alle Schaltungsmodelle mit dem Stromversorgungsbaustein 28, s. auch Fig. 13.
Ein Sensor kann auf den Stromversorgungsbaustein 28 aufgesteckt sein, dessen Eingang über einen Steckverbinder auf einen 0,64 Buchsenanschluß geführt ist. Über weitere Buchsen läßt sich die Störstromeinspeisung durch den Burstgenerator vornehmen.

Mit dem Schaltungsmodell M in Fig. 7 werden magnetisch wirksame Öffnungen 23 in GND-Flächen 20 untersucht. Die Abdeckung der Öffnung 23 erfolgt mit einer oder mit zwei geschlossenen GND-Flächen 30, die über die Öffnung geschoben werden.

In der Öffnung 23 ist ein Signalleiterzug 31 angeordnet, der auf einer Seite mit der GND-Fläche 20 und auf der anderen Seite mit dem Eingang eines Sensors oder dem Eingang eines zwischengeschalteten IC verbunden ist.
Der in der Öffnung 23 angeordnete Signalleiterzug 31 kann auch beweglich ausgeführt und damit verschiebbar sein.

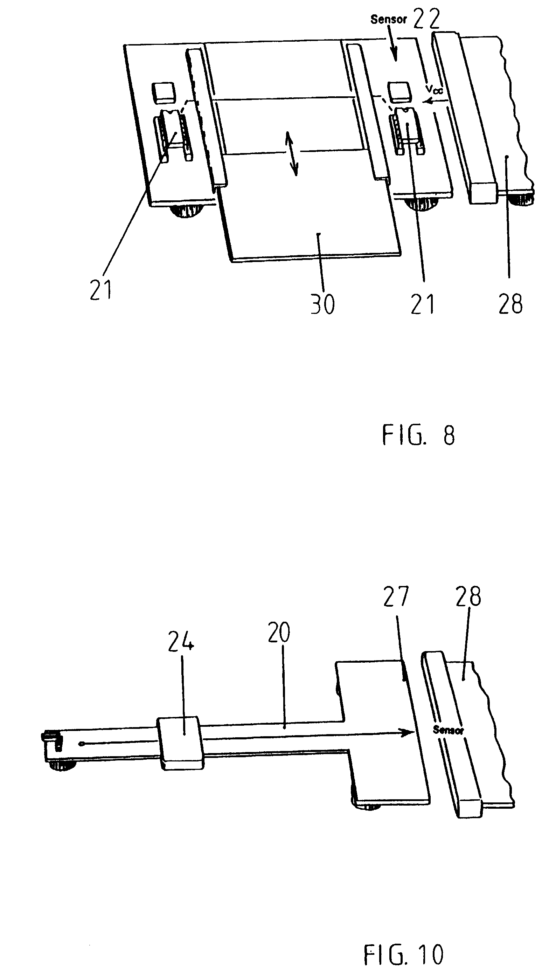

Mit dem Schaltungsmodell K in Fig. 8 lassen sich universelle Untersuchungen der elektrischen, magnetischen und induktiven Beeinflussungskomponenten sowie der EMV-Eigenschaften von IC 21 durchführen.

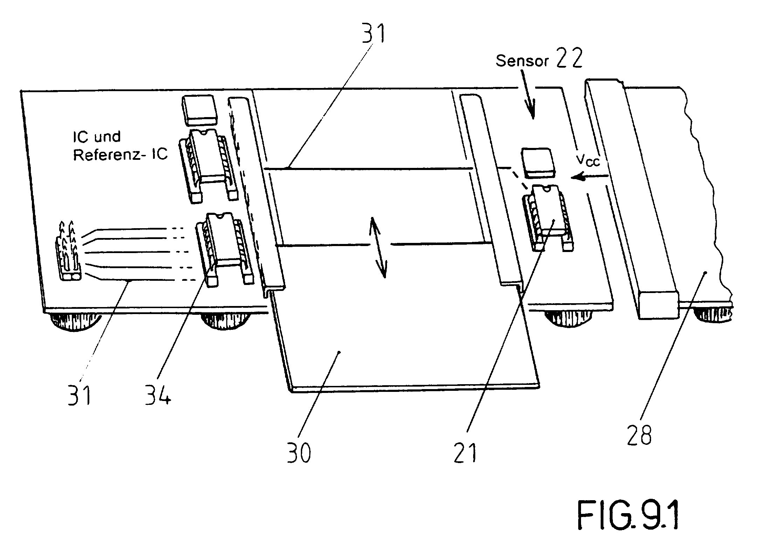

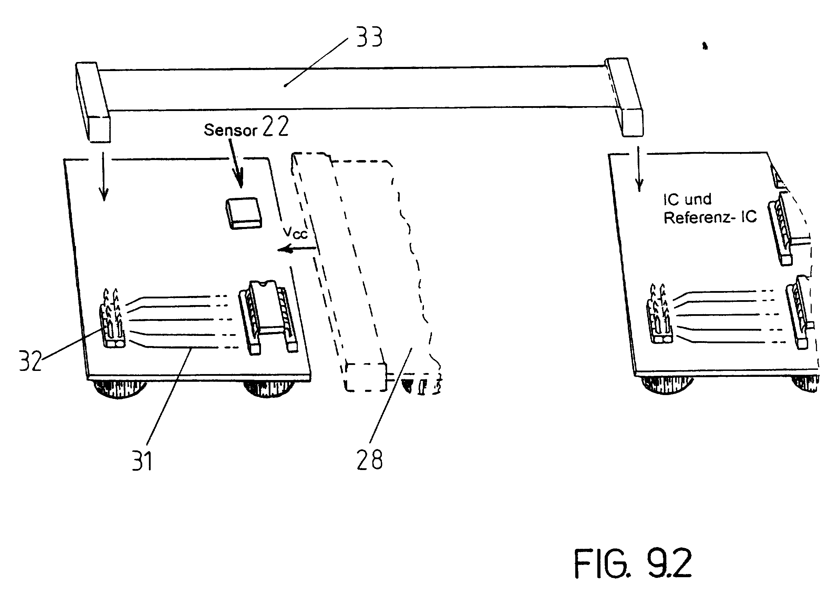

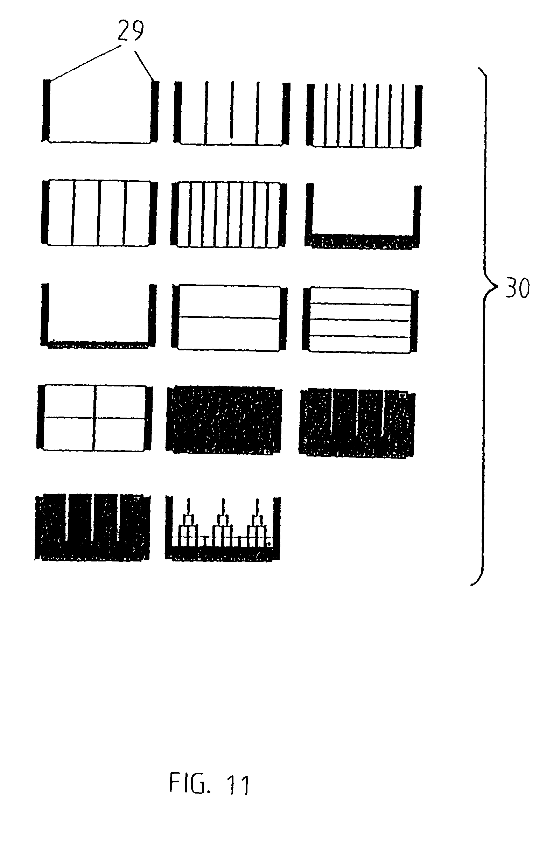

Ein EMV-Sensor 22 kann direkt an die Signalverbindung oder durch Zwischenschalten eines IC angeschlossen werden. Die Herstellung variabler GND-Verhältnisse erfolgt durch Einschieben speziell gestalteter GND-Flächen 30, s. auch Fig. 11.

Fig. 9.1 und 9.2 zeigen die Schaltungsmodelle G01 bzw. G02, die der universellen Untersuchung von Beeinflussungsproblemen bei der Verbindung von Baugruppen dienen.
Die Verbindung zu einer anderen Baugruppe, im Untersuchungsfall nachgebildet durch das Schaltungsmodell G02 nach Fig. 9.2 erfolgt über die Pfostenleiste 32 und eine Bandleitung 33.
Beim Schaltungsmodell G02 nach Fig. 9.2 kann über einen direkten Steckverbinder eine Verbindung mit anderen Schaltungsmodellen oder der Stromversorgung 28 hergestellt werden. Die Hilfsenergie zum Betreiben der Baugruppe kann direkt aus 28 entnommen oder über die Bandleitung 33 eingespeist werden.

Fig. 10 zeigt das Schaltungsmodell I, es wird verwendet zur Realisierung der induktiven Beeinflussungskomponente.
Wesentliche Merkmale sind der 20 mm breite GND-Leiterzug 20, in den Störstrom eingespeist wird, und der auf diesem Leiterzug gleitende Schleifer 24 zum Abgreifen von Längsspannungen.
Die Verbindung mit dem Stromversorgungsbaustein 28 erfolgt durch einen direkten Steckverbinder 27.

Fig. 11 veranschaulicht eine Auswahl von GND-Flächen 30 mit geometrisch unterschiedlich gestalteten Strukturen.

Alle GND-Flächen haben die zum Einschub, beispielsweise in das Schaltungsmodell K in Fig. 8, erforderlichen gleichen Rastermaße und verfügen beidseitig über Gleitschienen 29.

Die einzelnen Strukturen der aufgebrachten GND-Rasterlinien ermöglichen für die elektrische, magnetische, und induktive Komponente die Simulation unterschiedlicher Beeinflussungsverhältnisse. Dazu sind beispielsweise Leiterbahnen quer und/oder längs zur Feldrichtung der elektrischen und magnetischen Komponente angeordnet und der diese Stukturen durchfließende Störstrom wird dadurch für diese konkreten Verhältnisse auswertbar, d.h. die Auswirkungen auf die jeweilige Schaltungen können meßtechnisch durch EMV-Sensoren oder durch dem Sensor vorgeschaltete IC oder mit Magnetfeldsonden erfaßt werden.

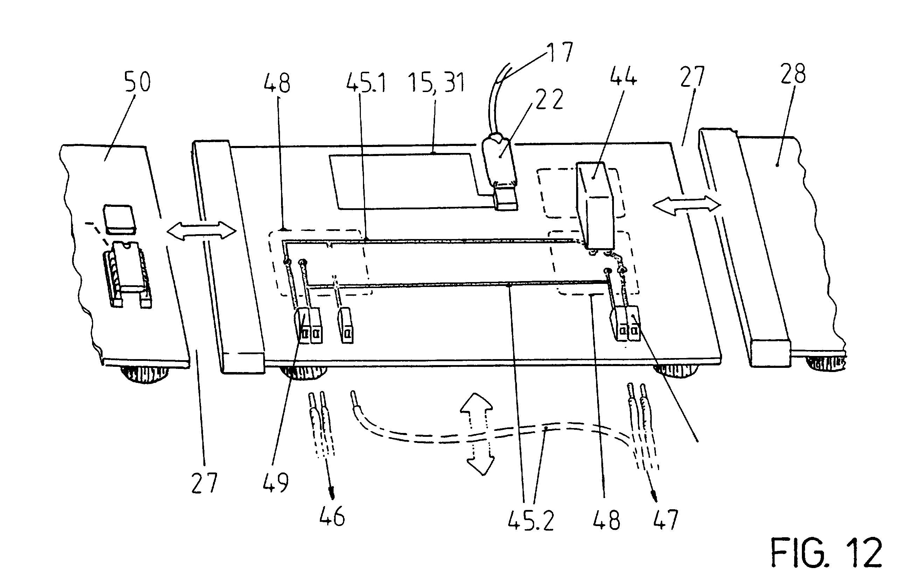

In Fig. 12 ist die prinzipielle Ausführung des Schaltungsmodells R dargestellt.
Auf dem Schaltungsmodell befinden sich Buchsen zum Aufstecken von Relais 44, Verbindungs- und Beschaltungsfelder (VBF) 48 auf der Einspeiseseite und der Relaisseite dienen der Verbindung der Versorgungsschienen 45 und der Aufnahme von Beschaltungselementen (Entstörkondensatoren, Varistoren, ...). Der spannungsführende Leiter der Versorgungsschiene 45.1 ist fest angeordnet. Der Rückleiter 45.2 ist fest oder flexibel als Leitung ausgeführt, um die Lage zum spannungsführenden Leiter beliebig veränderlich zu gestalten.
Über Steckverbinder bzw. Klemmen 49 können die Leitungen der Steuerspannung 46 und die Last 47 angeschlossen werden.

Die beeinflussende Wirkung des Schaltens ist über mehrere Wege erfaßbar:
Einmal über eine fest angeordnete Signalleiterschleife 15 mit aufsteckbarem EMV-Sensor 22; weiterhin über Schaltungsmodelle 50 (K, G), die über einen direkten Steckverbinder 27 ansteckbar sind; des weiteren über spezielle an verschiedenen Orten des Schaltungsmodelles R plazierte Sensoren oder über B- und E-Feldsonden.
Die Steuerung der Relais erfolgt durch einen auf das Schaltungsmodell R aufgesteckten Signalgenerator SQ oder über einen direkten Steckverbinder aus einem anderen Schaltungsmodell.

Das Schnittstellenmodell SM nach Fig. 13 ist für die EMV-Dimensionierung von Signaleingängen an Schnittstellen konzipiert. Schnittstellenschaltungen werden durch Aufstecken von Bauelementen 25, beispielsweise Trans-Zorb, Varistoren, Kondensatoren, Widerstände oder durch Zuschalten derartiger interner Bauelemente über DIL-Schalter realisiert.
Die Einstellung der erforderlichen IC-Empfindlichkeit erfolgt durch Aufstecken entsprechender EMV-Sensoren oder spezieller Bauelemente 26 (IC, Optokoppler usw.) auf einen (bis 16poligen) IC-Adapter.
Die Schaltungsteile mit den Eingängen E1/E2 sind für Untersuchungen schneller, energiearmer Störgrößen (Burst) vorgesehen, und die Schaltungsteile mit den Eingängen E3/E4 sind für die Untersuchung energiereicher Störgrößen (Blitz 1,2/50; 8/20) geeignet. Die Eingänge E1/E2 sind über die Buchsenleiste eines direkten Steckverbinders 27 mit weiteren Schaltungsmodellen verbindbar.

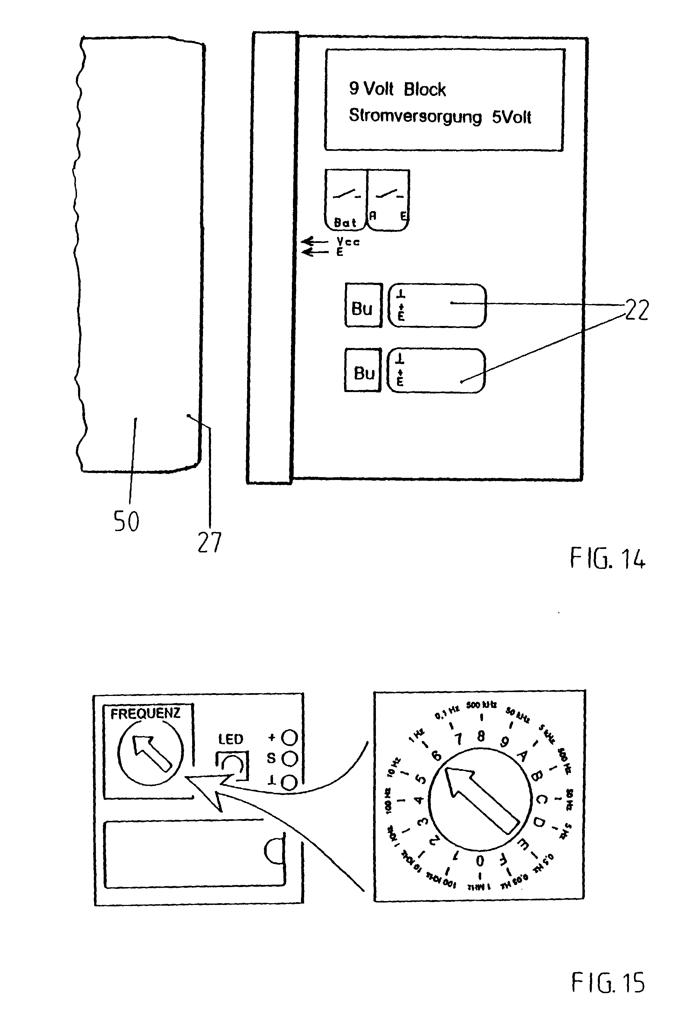

Die Hilfsenergieversorgung erfolgt über einen direkten Steckverbinder 27 aus dem Stromversorgungsbaustein 28 nach Fig. 14.
Der Stromversorgungsbaustein SV nach Fig. 13 gewährleistet die galvanisch getrennte 5 V-Spannungsversorgung von EMV-Sensoren.

Die Verbindung mit einem Schaltungsmodell erfolgt wiederum mittels direktem Steckverbinder 27, über den die GND-Fläche, je zwei Sensoreingänge und V_{cc}-Verbindungen geführt sind.
Die Hilfsenergie wird von einer 9 V Block-Batterie entnommen.

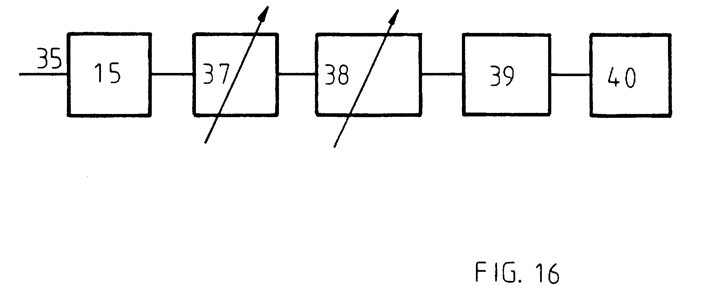

Weitere Merkmale der Stromversorgungseinheit sind die LED-Anzeige für V_{cc} (5 Volt), ein Prüftaster für Batteriezustand, Steckplätze für zwei EMV-Sensoren, Steckbrücken für Verbindungen zum direkten Steckverbinder (Sensoreingänge und V_{cc}), eine Feinsicherung für Latch-up-Schutz bei V_{cc} Fremdeinspeisung und das Vorhandensein von 4 mm- und 1 mm Buchse sowie 0,64 mm Stifte für den Störgeneratoranschluß.
Der quarzstabilisierte Signalgenerator SQ nach Fig. 15 wird auf den erfindungsgemäßen Schaltungsmodellen aufgesteckt.
Seine Frequenz ist in 16 Stufen zwischen 1 MHZ und 0,05 HZ verstellbar. Sein Tastverhältnis ist 1 : 1, er besitzt einen TTL-Ausgang und die Frequenzanzeige erfolgt mittels LED.
Mit einem Erweiterungsbaustein ist das Tastverhältnis veränderbar.

Dem Schaltungsmodell SM kann ein weiteres Schaltungsmodell durch Anstecken an einen direkten Steckverbinder vorgeordnet werden. Diese Schaltungsmodelle können spezielle Schnittstellenmodelle sein, z.B. Modelle, in denen verschiedene Kabelarten, Schirmanschlußvarianten, Steckverbindervarianten usw. getestet werden können.

In Fig. 16 wird der als EMV-Sensor 22 eingesetzte Kabel- und Gerätesensor anhand eines Blockschaltbildes dargestellt.
Die leitungsgebundene Störgröße 35 wird von einer Erfassungseinheit 15 aufgenommen und kann in ihrer Größe durch eine Baugruppe 37 zur Verstellung der elektromagnetischen Eigenschaften verändert werden. Diese Veränderung bzw. Verstellung entspricht dabei dem ersten Sensorparameter, der die Kopplung des zu überwachenden Gerätes nachbildet.

Mit der Einheit für den zweiten Sensorparameter 38 wird die IC-Empfindlichkeit des zu überwachenden Gerätes, der Baugruppe oder Schaltung berücksichtigt und damit die zugehörige dynamische Schaltschwelle nachgebildet. Die Impulsformer-/Treiberstufe 39 und die nachgeschaltete Anzeige/Ausgabeeinheit 40 komplettieren den Meßsensor.
Alle Bauelemente bzw. Baugruppen sind in Reihe geschaltet.

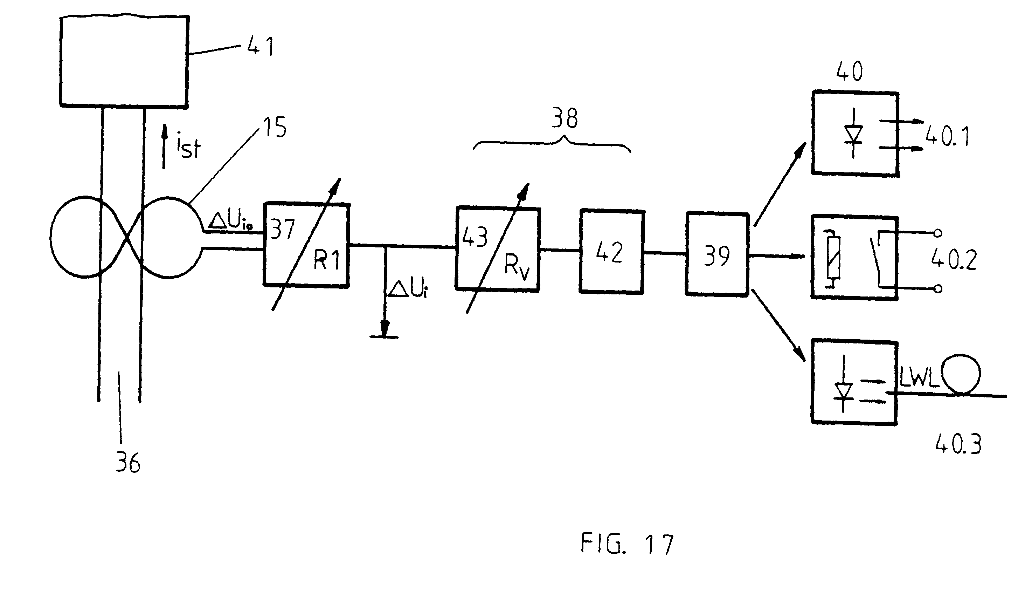

Fig. 17 veranschaulicht den erfindungsgemäßen Kabel- und Gerätesensor mit zwei verstellbaren Sensorparametern anhand eines Blockschaltbildes, in das alle für die Ausführung eines derartigen Meßsensors erforderlichen Baugruppen bzw. Bauelemente eingezeichnet sind.

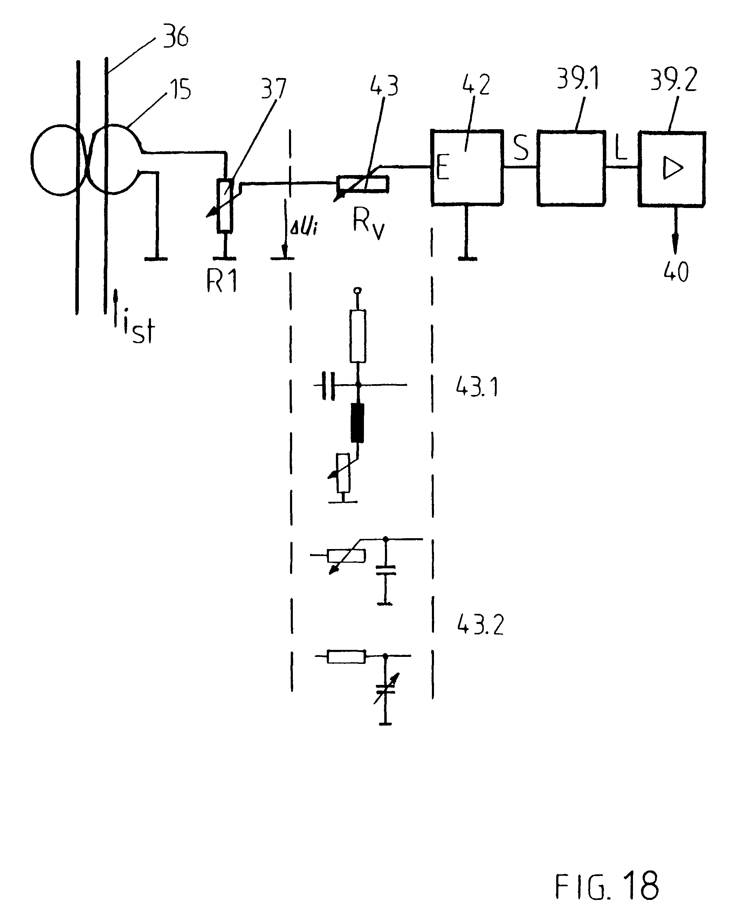

Eine ausgeführte Schaltung auf der Grundlage dieses Blockschaltbildes nach Fig. 17 ist in Fig. 18 dargestellt.

Die in Form einer Acht ausgeführte Induktionschleife 15 erfaßt das durch den über die Anschlußleitung 36 für das zu überwachende Gerät 41 fließenden Störstrom iₛₜ verursachte Magnetfeld.
In der Induktionsschleife 15 wird eine Spannung ΔUᵢₒ induziert. Mit der Induktionsschleife werden die elektromagnetischen Geräteeigenschaften nachgebildet. Die Schleife verhält sich ähnlich wie ein Signalleiterzug in einer Geräteschaltung. Die Stärke der Kopplung läßt sich durch einen Spannungsteiler R1 (Bauelement 37) variieren.
Es entsteht die Spannung ΔUᵢ, die auf die dynamische Schaltschwelle eines IC-Eingangs (Bauelement 42) wirkt.

Durch den Vorwiderstand Rᵥ (Bauelement 43) wird die IC-Empfindlichkeit speziell für bipolare IC-Eingänge verändert. Der Eingang E stellt den Eingang eines IC dar, der eine definierte dynamische Schaltschwelle besitzt und zu einer bestimmten IC-Familie gehört. Am Eingang E wird ΔUᵢ in ein logisches Signal S umgewandelt. Durch den Impulsformer 39.1 wird das logische Signal in ein Signal L definierter Länge umgewandelt. Das logische Signal S hat die Dauer von einigen ns und wird von der Impulsformerstufe 39.1 verlängert, so daß es weiter verarbeitbar ist.
Das Ausgangssignal des Treibers 39.2 kann z.B. ein Relais 40.2 ansteuern.

Weiterhin kann als Anzeige- oder Ausgabeeinheit 40 dem Treiber 39.2 eine LED 10.1 nachgeschaltet werden, mit der das Signal direkt am kompakten Meßsystem/Meßsensor sichtbar gemacht werden kann. Dazu ist die LED-Anzeige auf der Frontseite in das Gehäuse des Meßsensors integriert.

Eine andere Anzeige-/Ausgabemöglichkeit ist mit Optokoppler oder optischem Sender und Lichtwellenleiter LWL (Baugruppe 40.3) gegeben.
Alternative Bauelemente 43 zur Verstellung der IC-Empfindlichkeit sind in Fig. 18 mittels einer IC-Empfindlichkeitsverstellung durch Potentialanhebung 43.1 sowie durch Tiefpaß 43.2 dargestellt.

## Patentansprüche

1. Meß- und Experimentiersystem zur Erfassung und Bewertung des EMV-Verhaltens elektrischer Geräte, Baugruppen und Schaltungen auf der Basis des geräteinternen Wandlungsmechnismus von Störgrößen in logische Veränderungen, wobei das erzeugte Störsignal bei Überschreiten einer Schaltschwelle, die auf die Empfindlichkeit der in der Schaltung verwendeten IC's (21, 42) und EMV-Sensoren (22) abgestimmt ist, ein logisches Signal erzeugt,
**dadurch gekennzeichnet**, daß zur Erzeugung konkreter Beeinflussungssituationen folgende Module bzw. Funktionsbausteine im Meß- und Experimentiersystem verknüpft sind
- Burstgenerator/Zähler,
- Induktionsschleife (15) oder Magnetfeldsonde,
- Schaltungsmodell U zur Untersuchung der elektrischen und magnetischen Beeinflussungskomponenten,
- Schaltungsmodell M zur Untersuchung magnetisch wirksamer Öffnungen (23) in GND-Flächen (20),
- Schaltungsmodell K für universelle Untersuchungen der elektrischen, magnetischen und induktiven Beeinflussungskomponenten und der EMV-Eigenschaften von IC (21),
- GND-Flächen (30) zum Einschieben in die dafür vorgesehenen Schaltungsmodelle,
- Schaltungsmodell G01 und G02 zur universellen Untersuchung von Beeinflussungsproblemen bei der Verbindung von Geräten, Baugruppen und Schaltungen
- Schaltungsmodell I zur Realisierung der induktiven Beeinflussungskomponente,
- Schaltungsmodell R zur Untersuchung von Störgrößen und Beeinflussungsvorgängen, die durch schaltende Kontakte hervorgerufen werden,
- Schnittstellenmodell SM zur EMV-Dimensionierung von Signaleingängen an Schnittstellen,
- optoelektronischer Wandler mit Lichtwellenleitereingang und TTL-, offenen Kollektor- oder Relaisausgang,
- Stromversorgungsbaustein SV zur galvanisch getrennten 5 V Spannungsversorgung von Schaltungsmodellen bzw. EMV-Sensoren,
- quarzstabilisierter Signalgenerator zum Aufstecken auf die eingesetzten Schaltungsmodelle,
- PC-Modul,
- EMV-Sensor in der Ausführung als aufsteckbarer Miniatursensor (22) mit feststehender Empfindlichkeit und Kopplung sowie als Kabel- und Gerätesensor.

2. Meß- und Experimentiersystem nach Anspruch 1,
**dadurch gekennzeichnet**, daß der Burstgenerator/Zähler die für das Impulsdichteverfahren notwendigen drei Einzelfunktionen Burstgenerator, Optischer Empfänger (4) und Frequenzzähler in einem Gerät beinhaltet, wobei die Steilheit der Burstimpulse verstellbar ist, der Optische Empfänger über einen Lichtwellenleiter mit einem EMV-Sensor sowie intern mit dem Frequenzzähler verbunden ist.

3. Meß- und Experimentiersystem nach Anspruch 1,
**dadurch gekennzeichnet**, daß der Störgenerator aus einem mit Hochspannungsimpulsen (5) der Frequenz f₁ periodisch aufgeladenen Kondensator C (6) besteht und parallel zu diesem Kondensator eine in ihrer Schlagweite s nach der Frequenz f₂ periodisch veränderliche Funkenstrecke (7) angeordnet ist, wobei
- die Funkenstrecke (7) über ein mit der Frequenz f₂ schwingendes und in seiner Frequenz steuerbares mechanisches System verfügt, das eine pendelnde oder rotierende Bewegung der Kontakte der Funkenstrecke bewirkt,
- sich die Schlagweite s der Funkenstrecke (7) nach einer bestimmten Zeitfunktion verändert,
- die Entladung der Funkenstrecke (7) über das Netzwerk R (8) erfolgt,
- mit dem Netzwerk R die Impulsform der Entladung veränderbar ist,
- die Auskopplung der Störimpulse (9) über den Kondensator (6) oder das Netzwerk (8) erfolgt.

4. Meß- und Experimentiersystem nach Anspruch 3,
**dadurch gekennzeichnet**, daß als pendelndes bzw. schwingendes System der Kontakte einer Funkenstrecke (7) das Kontaktsystem eines Relais vorgesehen ist, wobei das Relais von einem Frequenzgenerator (10) mit der Frequenz f₂ beaufschlagt ist.

5. Meß- und Experimentiersystem nach Anspruch 3,
**dadurch gekennzeichnet**, daß zur Ausführung einer rotierenden Bewegung der Kontakte der Funkenstrecke (7) exzentrisch geformte rotierende Kurvenscheiben vorhanden sind.

6. Meß- und Experimentiersystem nach Anspruch 1,
**dadurch gekennzeichnet**, daß die Magnetfeldsonde aus einer Induktionsschleife (15), einem optischen Sender (16) und einem Lichtwellenleiter (17) besteht, wobei die Schleife (15) flexibel als Kabel oder als starres Formelement ausgeführt ist.

7. Meß- und Experimentiersystem nach Anspruch 6,
**dadurch gekennzeichnet**, daß zur Erhöhung und zur Regulierung der Empfindlichkeit der Sonde eine Konstantstromquelle (19) vorhanden ist, wobei der Konstantstrom in der Sendediode (16) dem Strom der Induktionsschleife (15) überlagert ist.

8. Meß- und Experimentiersystem nach Anspruch 6 oder 7,
**dadurch gekennzeichnet**, daß zur Impulsverlängerung in Reihe oder parallel zum optischen Sender (16) schnelle Dioden und zusätzlich Kondensatoren und Widerstände vorsehbar sind.

9. Meß- und Experimentiersystem nach Anspruch 1,
**dadurch gekennzeichnet**, daß bei dem Schaltungsmodell U als Einkoppelstrukturen Leitungen oder die Induktionsschleife (15) angeschlossen sind.

10. Meß- und Experimentiersystem nach Anspruch 1,
**dadurch gekennzeichnet**, daß bei dem Schaltungsmodell M zur Abdeckung der im Schaltungsmodell befindlichen Öffnung (23) GND-Flächen (30) einer vorgegebenen Geometrie eingesetzt sind und das Schaltungsmodell einen Signalleiterzug (31) besitzt.

11. Meß- und Experimentiersystem nach Anspruch 1,
**dadurch gekennzeichnet**, daß beim Schaltungsmodell K durch Einschieben unterschiedlicher GND-Flächen (30) zwischen zwei IC (21) unterschiedliche Beeinflussungsbedingungen für die Signalverbindung nachgebildet sind, wobei IC mit bestimmten Eingangs- und Ausgangseigenschaften auf Fassungen aufsteckbar sind und ein EMV-Sensor (22) direkt an die Signalverbindung, oder durch Zwischenschalten eines IC angeschaltet ist.

12. Meß- und Experimentiersystem nach Anspruch 11,
**dadurch gekennzeichnet**, daß auf der Signalverbindung bestimmte logische Pegel über Steckbrücken oder durch Aufstecken eines Signalgenerators realisierbar sind.

13. Meß- und Experimentiersystem nach Anspruch 10 oder 11,
**dadurch gekennzeichnet**, daß auf den GND-Flächen (30) gleichen Rasters bestimmte geometrische GND-Strukturen realisiert sind.

14. Meß- und Experimentiersystem nach Anspruch 1,
**dadurch gekennzeichnet**, daß mit dem Schaltungsmodell G01 bei ähnlichem Aufbau wie das Modell K eine Signalverbindung zwischen zwei IC (21) nachgebildet ist und die zu untersuchende Verbindung zu einem anderen Gerät, Baugruppe oder Schaltung durch das über eine Pfostenleiste (32) und eine Leitung (33) angeschlossene Schaltungsmodell G02 erfolgt, wobei die Pfostenleiste (32) über Signalleiterzüge (31) mit den Ein- oder Ausgängen (34) eines IC verbindbar ist.

15. Meß- und Experimentiersystem nach Anspruch 1,
**dadurch gekennzeichnet**, daß beim Schaltungsmodell I ein mit Störstrom beaufschlagter GND-Leiterzug (20) vorhanden ist, von dem mittels eines Schleifers (24) und eines mit ihm verbundenen Signalleiterzuges (31) Längsspannungen abgreifbar sind.

16. Meß- und Experimentiersystem nach Anspruch 1,
**dadurch gekennzeichnet**, daß beim Schaltungsmodell R aufsteckbare Schaltkontakte, Schalter oder Relais (44) vorhanden sind, deren Kontaktsystem eine über Versorgungschienen (45) geführte Steuerspannung (46) auf eine Lastleitung (47) schaltet, wobei an den beiden Enden der Versorgungsschienen (45) Verbindungs- und Beschaltungsfelder VBF (48) angeordnet sind, die auf der einen Seite eine Verbindung zur Zuführung der Steuerspannung (46) und auf der anderen Seite zum Relais (44) sowie zur Last (47) herstellen.

17. Meß- und Experimentiersystem nach Anspruch 1,
**dadurch gekennzeichnet**, daß beim Schnittstellenmodell SM zum Aufbau von Schnittstellenschaltungen Bauelemente (25), wie Trans-Zorb, Varistoren, Kondensatoren, Widerstände usw. aufsteckbar sind oder durch Zuschalten interner Bauelemente vorgegeben sind, wobei die erforderliche IC-Empfindlichkeit durch Aufstecken entsprechender EMV-Sensoren (22) oder spezieller Bauelemente (26), wie IC, Optokoppler usw. auf einem IC-Adapter einstellbar ist.

18. Meß- und Experimentiersystem nach Anspruch 1,
**dadurch gekennzeichnet,** daß die Verbindung des Stromversorgungsbausteines SV (28) mit einem Schaltungsmodell (50) und die Verbindung von Schaltungsmodellen untereinander über einen direkten Steckverbinder (27) erfolgt, über den zumindest die GND-Fläche und Verbindungen für die Versorgungsspannung sowie weitere Signalleitungen geführt sind.

19. Meß- und Experimentiersystem nach Anspruch 1,
**dadurch gekennzeichnet,** daß dem für die Steuerung und Auswertung der Meß- und Experimentierprozesse eingesetzten PC ein PC-Modul vorgeschaltet ist, das die von den Schaltungsmodellen, Prüflingen und EMV-Sensoren eingehenden Signale vorverarbeitet, den PC mit speziellen logischen Strukturen bezüglich der Echtzeitverarbeitung aller aufzunehmenden und abzugebenden Signale unterstützt und die Steuerung des Burstgenerators und der Schaltungsmodelle bzw. Prüflinge durchführt.

20. Meß- und Experimentiersystem nach Anspruch 1,
**dadurch gekennzeichnet**f, daß als EMV-Sensor (22) ein Kabel- und Gerätesensor eingesetzt wird, der die Empfindlichkeit von elektrischen Geräten, Baugruppen oder Schaltungen im Sinne der vorhandenen physischen Robustheit des Gerätes, der Baugruppen oder der elektronischen Schaltung nachbildet, wobei eine Sensorkomponente des Meßsystems als 1. Parameter die Kopplung und eine weitere Sensorkomponente als 2. Parameter die IC-Empfindlichkeit nachbildet und die Erfassung der Störgröße (35) durch das Meßsystem kontinuierlich oder in diskreten Schritten während einer vorgegebenen Meßzeit mittels des vom Störstrom iₛₜ erzeugten Magnetfeldes des zum Gerät (41) führenden Kabels (36) (oder im Gerät befindlicher Leitungen, Leiterzüge und leitfähiger Konstruktionsteile) und/oder über das vorhandene elektrische Feld und/oder auf induktivem Weg durch Auswertung des an der Induktivität des Kabels oder der Leitung (36) erzeugten Spannungsabfalls erfolgt.

21. Meß- und Experimentiersystem nach Anspruch 20,
**dadurch gekennzeichnet**, daß der 1. Sensorparameter, der die Kopplung der Schaltung, der Baugruppe des elektrischen Gerätes (41) nachbildet, durch eine Erfassungseinheit (15) für die Störgröße (35) und eine Baugruppe (37) zur Verstellung der elektromagnetischen Eigenschaften und der 2. Sensorparameter durch eine Einheit (38) zur Nachbildung und Verstellung der IC-Empfindlichkeit realisiert ist, wobei der Reihenschaltung dieser Funktionseinheiten (15, 37, 38) eine Impulsformer-/Treiberstufe (37) sowie eine Anzeige- und/oder Ausgabeeinheit (40) nachgeschaltet sind.

22. Meß- und Experimentiersystem nach Anspruch 21,
**dadurch gekennzeichnet**, daß die IC-Empfindlichkeit des Kabel- und Gerätesensors in diskreten Schritten durch Austausch von IC-Steckmodulen definierter Empfindlichkeit veränderlich ist.

23. Meß- und Experimentiersystem nach Anspruch 21 oder 22,
**dadurch gekennzeichnet**, daß die Induktionsschleife (15) in einen kompakt ausgeführten Kabel- und Gerätesensor fest eingebaut ist, oder über Steckverbinder von außen aufsteckbar ist, oder über Steckverbinder der Kabel- und Gerätesensor mit geräteinternen Leiterschleifen verbunden ist.

24. Meß- und Experimentiersystem nach einem der Ansprüche 21 bis 23,
**dadurch gekennzeichnet**, daß als Erfassungseinrichtung (15) ein elektrisch leitfähiges Plattenpaar zur Erfassung der elektrischen Komponente verhanden ist und das Plattenpaar analog einem Plattenkondensator aufgebaut ist, wobei sich die Platten gegenüber stehen oder in gestreckter Ausführung in einer Ebene neben- bzw. hintereinander angeordnet sind, und eine Platte des Kondensators von den leitfähigen Teilen des Gerätes, der Baugruppe oder der Schaltung gebildet werden kann.

25. Meß- und Experimentiersystem nach einem der Ansprüche 22 bis 24,
**dadurch gekennzeichnet**, daß als Baugruppe (37) zur Verstellung der elektromagnetischen Geräteeigenschaften ein Spannungsteiler R1 vorgesehen ist, der der Induktionsschleife (15) nachgeschaltet ist.

26. Meß- und Experimentiersystem nach einem der Ansprüche 22 bis 25,
**dadurch gekennzeichnet**, daß die Einheit (38) zur Berücksichtigung bzw. Verstellung der IC-Empfindlichkeit durch einen IC (42) und eine Schaltung zur Verringerung der statischen und dynamischen Schaltschwelle durch Potentialanhebung bzw. Stromüberlagerung oder Erhöhung der dynamischen Schaltschwelle durch Tiefpaßeinsatz dem Eingang E des IC vorgeschaltet ist.

## Claims

1. Measuring and experimenting system for the sensing of the EMP susceptibility of electrical appliances or circuits based on the appliance-internal conversion mechanism of interference quantities into logical changes whereby the interference signal produced generates when a switching threshold that is adapted to the susceptibility of the ICs (21, 42) and EMP sensors (22) used in the circuit is exceeded, a logical signal
**wherein** in order to cause actual interference situations the following modules or functional components, respectively, are linked with each other
- burst generator/counter;
- induction loop (15) or magnetic field probe;
- circuit model U for the analysis of the electric and magnetic interference components;
- circuit model M for the investigation of magnetically effective openings (23) in GND surfaces (20);
- circuit model K for universal analyses of the electric, magnetic and inductive interference components and EMP properties of ICs (21);
- GND surfaces (30) for the insertion into the circuit models provided therefore;
- circuit model G01 and G02 for the universal analysis of interference problems due to the connection of devices, assemblies and circuits;
- circuit model I for the realization of the inductive interference component;
- circuit model R for the investigation of interference quantities and interference processes that are due to the switching of contacts,
- interface model SM for the EMP dimensioning of signal inputs at interfaces,
- opto-electronic converter with optical waveguide input and TTL-, open collector- or relay output,
- power supply module SV for the indirect coupled 5V voltage supply of circuit models or EMP sensors, respectively,
- quartz stabilized signal generator for the clipping onto the circuit models inserted,
- PC module,
- EMP sensor designed as a miniature sensor (22) that can be clipped on, with fixed susceptibility and coupling as well as a cable and appliance sensor.

2. Measuring and experimenting system of Claim 1
**wherein** the burst generator/counter comprises the three single functions necessary for the pulse rate method, namely burst generator, optical receiver (4) and frequency counter in one appliance whereby the slope of the burst pulses can be varied, the optical receiver is connected to an EMP sensor through an optical waveguide and internally to the frequency counter.

3. Measuring and experimenting system of Claim 1
**wherein** the interference generator consists of a capacitor that is periodically charged with high-voltage pulses (5) of the frequency f₁ and parallel with this capacitor a spark gap (7) is arranged the sparking distance s of which varies at the frequency f₂ whereby
- the spark gap (7) has a mechanical system oscillating at the frequency fi and with the frequency of which being capable to be controlled, which causes a swinging or rotating movement of the spark gap,
- the sparking distance s of the spark gap (7) changes following a certain time function,
- the discharge of the spark gap (7) occurs through the network R (8),
- the pulse shape of the discharge can be varied with the network R,
- the interference pulses (9) are coupled out through the capacitor (6) or the network (8).

4. Measuring and experimenting system of Claim 3
**wherein** as the swinging or oscillating system of the contacts of a spark gap (7) the contact system of a relay is provided whereby the relay is pulsed from a frequency generator (10) at a frequency f₂.

5. Measuring and experimenting system of Claim 3
**wherein** for the execution of a rotating movement of the contacts of the spark gap (7), excentrically shaped cam disks are provided.

6. Measuring and experimenting system of Claim 1
**wherein** the magnetic field probe consists of an induction loop (15), an optical receiver (16) and an optical waveguide (17) whereby the loop (15) is designed flexible as cable or as a rigid form element.

7. Measuring and experimenting system of Claim 6
**wherein** to increase and control the susceptibility of the probe a constant-current source (19) is provided whereby the constant current in the transmitting diode (16) is superimposed to the current of the induction loop (15).

8. Measuring and experimenting system of Claim 6 or 7
**wherein** to prolong the pulses in series or parallel with the optical transmitter (16) fast diodes and, additionally, capacitors and resistors can be provided.

9. Measuring and experimenting system of Claim 1
**wherein** in the circuit model U lines or the induction loop (15) are connected as coupling-in structures.

10. Measuring and experimenting system of Claim 1
**wherein** in the circuit model M for the covering of the opening (23) existing in the circuit model GND surfaces (30) of a predetermined geometry are provided and the circuit model has a signal path track (31).

11. Measuring and experimenting system of Claim 1
**wherein** in the circuit model K by insertion of different GND surfaces (30) between two ICs (21), different interference conditions are simulated for the signal connection whereby ICs with certain input and output properties can be clipped onto sockets and an EMP sensor (22) is directly connected to the signal connection, or by interconnection of an IC.

12. Measuring and experimenting system of Claim 11
**wherein** on the signal connection certain logical levels can be realized through plug-in bridges or by clipping-on of a signal generator.

13. Measuring and experimenting system of Claim 10 or 11
**wherein** certain geometrical GND structures are realized on the GND surfaces (30) of equal pitch.

14. Measuring and experimenting system of Claim 1
**wherein** by means of the circuit model G01 designed similar to the model K, a signal connection between two ICs (21) is simulated and the connection to be analyzed leading to another appliance or circuit is through the circuit model G02 connected by a pin connector (32) and a line (33) whereby the pin connector (32) can be connected to the inputs or outputs (34) of an IC via signal path tracks.

15. Measuring and experimenting system of Claim 1
**wherein** in the circuit model I a GND line track (20) loaded with an interference current is provided from which direct-axis voltages can be tapped by means of a slider (24) and a signal path track (31) connected with it.

16. Measuring and experimenting system of Claim 1
**wherein** in the circuit model R switching contacts, switches or relays (44) that can be clipped-on are provided the contact system of which switches a control voltage (46) led through supply bars (45) onto a load line (47) whereby at both ends of the supply bars (45) patch and wiring bays (48) are arranged that form a connection, on the one side, to the feeding of the control voltage (46) and, on the other side, to the relay (44) and the load (47).

17. Measuring and experimenting system of Claim 1
**wherein** in the interface model SM components (25), such as transzorb, varistors, capacitors, resistors etc. can be clipped-on or are, as internal components, available by switching-on to build interface circuits whereby the required IC susceptibility can be adjusted by clipping-on of appropriate EMP sensors (22) or special components (26), such as ICs, opto-coupler, etc., onto an IC adapter.

18. Measuring and experimenting system of Claim 1
**wherein** the connection of the power supply component SV (28) to a circuit model (50) and the connection of circuit models with each other is carried out by means of a direct plug connector (27) through which, at least, the GND surface and connections for voltage supply as well as other signal lines are routed.

19. Measuring and experimenting system of Claim 1
**wherein** ahead of the PC used for the control and evaluation of the measuring and experimenting processes, a PC module is arranged that pre-processes the signals delivered from the circuit models, specimens and EMP sensors, supports the PC with special logical structures concerning the real-time processing of all signals to be received and delivered and carries out the control of the burst generator and circuit models or specimens, respectively.

20. Measuring and experimenting system of Claim 1
**wherein** as an EMP sensor (22) a cable and appliance sensor is used that simulates the susceptibility of electrical appliances or circuits in terms of the existing physical robustness of the appliance or electronic circuit whereby a sensor component of the measuring system simulates the coupling as the first parameter and another sensor component simulates the IC susceptibility as the second parameter, and the sensing of the interference quantity (35) is carried out by the measuring system continuously or in discrete steps during a predetermined measuring period by means of the magnetic field due to the interference current iₛₜ of the cable (36) leading to the appliance (41) (or of lines, line tracks or conductive structural parts) and/or via the given electrical field and/or inductively by evaluation of the voltage drop due to the inductivity of the cable or line (36).

21. Measuring and experimenting system of Claim 20
**wherein** the first sensor parameter, which simulates the coupling of the circuit of the electrical appliance (41), is realized by a sensing unit (15) for the interference quantity (35) and a component (37) for the adjustment of the electrical properties and the second sensor parameter by a unit (38) for the simulation and adjustment of the IC susceptibility whereby on the outlet of the series connection of these functional units (15, 37, 38) a pulse-forming/driving stage (37) and an indicating and/or output unit (40) are connected.

22. Measuring and experimenting system of Claim 21
**wherein** the IC susceptibility of the cable and appliance sensor can be varied in discrete steps by the exchanging of IC plug modules with defined susceptibilities.

23. Measuring and experimenting system of Claim 21 or 22
**wherein** the induction loop (15) is permanently installed in a compact cable and appliance sensor or can be clipped-on from the exterior or the cable and appliance sensor is connected to appliance-internal line loops through plug connectors.

24. Measuring and experimenting system of Claim 21 through 23
**wherein** as a sensing device (15) there is a conductive plate couple for sensing of the electrical component and the plate couple is designed similar to a plate capacitor whereby the plates face each other or are arranged side by side or after each other in one plane in a straight design, and one plate of the capacitor can be formed by the conductive parts of the appliance or circuit.

25. Measuring and experimenting system of Claim 22 through 24
**wherein** as module (39) for the adjustment of the electromagnetic properties of the appliance a voltage divider R1 is provided which is connected in series on the outlet side of the induction loop (15).

26. Measuring and experimenting system of Claim 22 through 25
**wherein** the unit (38) to consider or adjust the IC susceptibility by an IC (42) and a circuit for the reduction of the static and dynamic switching threshold by potential lifting or current superposition, respectively, or by increasing the dynamic switching threshold by using a low pass are connected ahead of the input E of the IC.

## Revendications

1. Système de mesure et d'expérimentation pour enregistrer et évaluer le comportement EMV de montages, blocs et appareils électriques sur la base du mécanisme, interne à l'appareillage, de transformation de grandeurs perturbatrices en modifications logiques, le signal perturbateur produit produisant lui-même un signal logique en cas de dépassement d'un seuil de commutation qui est adapté à la sensibilité des détecteurs EMV (22) et des circuits intégrés (21, 42) utilisés dans le montage,
**caractérisé** en ce que, afin de produire des situations concrètes d'influence, les modules ou composants fonctionnels suivants sont liés dans le système de mesure et d'expérimentation :
- compteur/générateur d'éclats,
- boucle d'induction (15) ou sonde de champ magnétique,
- modèle de montage U pour analyser les composantes électrique et magnétique d'influence,
- modèle de montage M pour analyser des ouvertures (23) à action magnétique dans des plaques de terre (20),
- modèle de montage K pour des analyses universelles des composantes électrique, magnétique et inductive d'influence et des propriétés EMV du circuit intégré (21),
- plaques de terre (30) à insérer dans les modèles de montage prévus à cet effet,
- modèles de montage G01 et G02 pour l'analyse universelle de problèmes d'influence lors de la connexion de montages, blocs et appareils,
- modèle de montage I pour mettre en oeuvre la composante inductive d'influence,
- modèle de montage R pour analyser des grandeurs perturbatrices et des processus d'influence qui sont produits par des contacts fermés,
- modèle d'interfaces SM pour le dimensionnement EMV d'entrées de signaux aux interfaces,
- convertisseur optoélectronique avec entrée de conducteur optique et sortie TTL, de relais ou de collecteur ouvert,
- bloc d'alimentation électrique SV pour l'alimentation en tension 5V à coupure galvanique de modèles de montage ou de détecteurs EMV,
- générateur de signal stabilisé par quartz, à enficher sur les modèles de montages insérés,
- module d'ordinateur personnel,
- détecteur EMV réalisé sous forme de détecteur miniature enfichable (22), à sensibilité fixe et avec couplage, ainsi que sous forme de détecteur de câbles et d'appareils.

2. Système de mesure et d'expérimentation selon la revendication 1, **caractérisé** en ce que le compteur/générateur d'éclats englobe dans un même appareil les trois fonctions individuelles nécessaires pour le procédé de densité d'impulsions, à savoir générateur d'éclats, récepteur optique (4) et compteur de fréquence, la vitesse de croissance des impulsions en éclats étant réglable, et le récepteur optique étant relié à un détecteur EMV par l'intermédiaire d'un conducteur optique, ainsi qu'en interne au compteur de fréquence.

3. Système de mesure et d'expérimentation selon la revendication 1, **caractérisé** en ce que le générateur de perturbations est constitué d'un condensateur C (6) chargé périodiquement d'impulsions à haute tension (5) de fréquence f₁, et un éclateur (7), dont la distance d'éclatement s varie périodiquement selon la fréquence f₂, est disposé parallèlement à ce condensateur,
- l'éclateur (7) disposant d'un système mécanique vibrant à la fréquence f₂ et dont la fréquence peut être commandée, système qui produit un mouvement pendulaire ou rotatif des contacts de l'éclateur,
- la distance d'éclatement s de l'éclateur (7) se modifiant selon une fonction de temps donnée,
- la décharge de l'éclateur (7) s'effectuant par l'intermédiaire du réseau R (8),
- le réseau R permettant de modifier le profil d'impulsions de la décharge,
- le découplage des impulsions perturbatrices (9) s'effectuant par l'intermédiaire du condensateur (6) ou du réseau (8).

4. Système de mesure et d'expérimentation selon la revendication 3, **caractérisé** en ce que le système de contacts d'un relais est prévu comme système pendulaire ou oscillant des contacts d'un éclateur (7), le relais étant sollicité à la fréquence f₂ par un générateur de fréquence (10).

5. Système de mesure et d'expérimentation selon la revendication 3, **caractérisé** en ce que des disques de came rotatifs de forme excentrique sont présents afin de réaliser un mouvement rotatif des contacts de l'éclateur (7).

6. Système de mesure et d'expérimentation selon la revendication 1, **caractérisé** en ce que la sonde de champ magnétique est constituée d'une boucle d'induction (15), d'un émetteur optique (16) et d'un conducteur optique (17), la boucle (15) étant réalisée flexible sous forme de câble, ou bien sous la forme d'un élément façonné rigide.

7. Système de mesure et d'expérimentation selon la revendication 6, **caractérisé** en ce qu'une source (19) de courant constant est présente pour augmenter et réguler la sensibilité de la sonde, le courant constant étant superposé, dans la diode émettrice (16), au courant de la boucle d'induction (15).

8. Système de mesure et d'expérimentation selon la revendication 6 ou 7, **caractérisé** en ce que des diodes rapides, et des condensateurs et résistances supplémentaires, peuvent être prévues en série ou en parallèle avec l'émetteur optique (16) afin d'étaler les impulsions.

9. Système de mesure et d'expérimentation selon la revendication 1, **caractérisé** en ce que, dans le modèle de montage U, on raccorde des lignes électriques ou la boucle d'induction (15) comme structures de couplage.

10. Système de mesure et d'expérimentation selon la revendication 1, **caractérisé** en ce que, dans le modèle de montage M, on insère des plaques de terre (30) d'une géométrie prédéfinie afin de recouvrir l'ouverture (23) présente dans le modèle de montage, et le modèle de montage possède un tracé conducteur de signal (31).

11. Système de mesure et d'expérimentation selon la revendication 1, **caractérisé** en ce que, dans le modèle de montage K, on reproduit des conditions différentes d'influence pour la connexion de signal en insérant différentes plaques de terre (30) entre deux circuits intégrés (21), des circuits intégrés présentant des propriétés données d'entrée et de sortie pouvant être enfichés sur des prises, et un détecteur EMV (22) étant relié à la connexion de signal directement ou avec intercalation d'un circuit intégré.

12. Système de mesure et d'expérimentation selon la revendication 11, **caractérisé** en ce qu'on peut réaliser sur la connexion de signal des niveaux logiques donnés au moyen de ponts enfichables ou par l'enfichage d'un générateur de signal.

13. Système de mesure et d'expérimentation selon la revendication 10 ou 11, **caractérisé** en ce que des structures géométriques données de terre sont réalisées sur les plaques de terre (30), de même dimension modulaire.

14. Système de mesure et d'expérimentation selon la revendication 1, **caractérisé** en ce que, avec le modèle de montage G01, de structure analogue au modèle K, on reproduit une connexion de signal entre deux circuits intégrés (21), et la connexion à analyser, vers un autre appareil, bloc ou montage, s'effectue par le modèle de montage G02 raccordé par l'intermédiaire d'une barre de soutien (32) et d'une ligne (33), la barre de soutien (32) pouvant être connectée aux entrées ou sorties (34) d'un circuit intégré par l'intermédiaire de tracés conducteurs de signaux (31).

15. Système de mesure et d'expérimentation selon la revendication 1, **caractérisé** en ce que, dans le modèle de montage 1, un tracé conducteur de terre (20) sollicité en courant perturbateur est présent, d'où l'on peut prélever des tensions longitudinales au moyen d'un curseur (24) et d'un tracé conducteur de signal (31) relié à ce curseur.

16. Système de mesure et d'expérimentation selon la revendication 1, **caractérisé** en ce que, dans le modèle de montage R, des contacts de commutation enfichables, commutateurs ou relais (44) sont présents, dont le système de contacts connecte sur une ligne de charge (47) une tension de commande (46) amenée par des barres d'alimentation (45), des champs VBF de connexion et de branchement (48) étant disposés aux deux extrémités des barres d'alimentation (45), champs qui réalisent d'un côté une connexion vers l'amenée de la tension de commande (46), et de l'autre côté une liaison vers le relais (44) ainsi que vers la charge (47).

17. Système de mesure et d'expérimentation selon la revendication 1, **caractérisé** en ce que, dans le modèle d'interfaces SM, afin de réaliser des montages d'interfaces, on peut enficher des composants (25) tels que « trans-zorb », varistors, condensateurs, résistances, etc., ou les prédéfinir en raccordant des composants intemes, la sensibilité nécessaire du circuit intégré pouvant être réglée en enfichant, sur un adaptateur du circuit intégré, des détecteurs EMV correspondants (22) ou des composants spéciaux (26), tels que circuits intégrés, coupleurs optoélectroniques, etc.

18. Système de mesure et d'expérimentation selon la revendication 1, **caractérisé** en ce que la connexion du bloc d'alimentation électrique SV (28) à un modèle de montage (50) et la connexion de modèles de montage entre eux s'effectuent au moyen d'un connecteur enfichable direct (27), par l'intermédiaire duquel sont dirigées au moins la plaque de terre et les connexions pour la tension d'alimentation, ainsi que d'autres lignes de signaux.

19. Système de mesure et d'expérimentation selon la revendication 1, **caractérisé** en ce qu'un module d'ordinateur personnel est branché en amont de l'ordinateur personnel utilisé pour la commande et l'évaluation des processus de mesure et d'expérimentation, module qui effectue un traitement préalable des signaux provenant des modèles de montages, échantillons et détecteurs EMV, assiste l'ordinateur personnel par des structures logiques spéciales concernant le traitement en temps réel de tous les signaux à recevoir et à délivrer, et assure la commande du générateur d'éclats et des modèles de montages ou échantillons.

20. Système de mesure et d'expérimentation selon la revendication 1, **caractérisé** en ce qu'on utilise comme détecteur EMV (22) un détecteur de câbles et d'appareils qui reproduit la sensibilité de montages, blocs ou appareils électriques au sens de la robustesse physique existante de l'appareil, des blocs ou du montage électronique, une composante de détection du système de mesure reproduisant le couplage comme premier paramètre et une autre composante de détection reproduisant la sensibilité du circuit intégré comme second paramètre, et l'enregistrement de la grandeur perturbatrice (35) par le système de mesure s'effectuant en continu ou par étapes discontinues, pendant un temps de mesure prédéfini, au moyen du champ magnétique, produit par le courant perturbateur iₛₜ, du câble (36) menant à l'appareil (41) (ou de lignes, tracés conducteurs et éléments de construction conducteurs se trouvant dans l'appareil), et/ou par l'intermédiaire du champ électrique présent, et/ou par voie inductive, en évaluant la chute de tension produite sur l'inductance du câble ou de la ligne (36).

21. Système de mesure et d'expérimentation selon la revendication 20, **caractérisé** en ce que le premier paramètre de détection, qui reproduit le couplage du montage, du bloc ou de l'appareil électrique (41), est réalisé par une unité d'enregistrement (15) pour la grandeur perturbatrice (35) et un bloc (37) pour régler les propriétés électromagnétiques, et le second paramètre de détection est réalisé par une unité (38) pour reproduire et régler la sensibilité du circuit intégré, le montage en série de ces unités fonctionnelles (15, 37, 38) étant suivi d'un étage excitateur/formateur d'impulsions (37) ainsi que d'une unité (40) d'affichage et/ou d'édition.

22. Système de mesure et d'expérimentation selon la revendication 21, **caractérisé** en ce que la sensibilité du circuit intégré du détecteur de câbles et d'appareils peut être modifiée par étapes discontinues par le remplacement de modules enfichables de circuits intégrés de sensibilité définie.

23. Système de mesure et d'expérimentation selon la revendication 21 ou 22, **caractérisé** en ce que la boucle d'induction (15) est fixement installée dans un détecteur de câbles et d'appareils en exécution compacte, ou peut être enfichée de l'extérieur par l'intermédiaire de connecteurs enfichables, ou est reliée, par l'intermédiaire de connecteurs enfichables du détecteur de câbles et d'appareils, à des boucles conductrices internes à l'appareil.

24. Système de mesure et d'expérimentation selon une des revendications 21 à 23, **caractérisé** en ce qu'une paire de plaques électriquement conductrices est présente comme dispositif d'enregistrement (15) afin d'enregistrer la composante électrique, et la paire de plaques est d'une structure analogue à celle d'un condensateur à plaques, les plaques étant disposées en vis-à-vis ou, dans une exécution étirée, en juxtaposition ou succession dans un plan, et une plaque du condensateur pouvant être formée par les parties conductrices de l'appareil, bloc ou montage.

25. Système de mesure et d'expérimentation selon une des revendications 22 à 24, **caractérisé** en ce qu'un diviseur de tension R1, qui est monté à la suite de la boucle d'induction (15), est prévu comme bloc (37) pour le réglage des propriétés électromagnétiques de l'appareil.

26. Système de mesure et d'expérimentation selon une des revendications 22 à 25, **caractérisé** en ce que l'unité (38), destinée à prendre en compte ou régler la sensibilité du circuit intégré, est formée par un circuit intégré (42), et l'entrée E du circuit intégré est précédée d'un montage pour diminuer le seuil de commutation statique et dynamique par augmentation de potentiel ou superposition de courant, ou pour augmenter le seuil de commutation dynamique par insertion d'un passe-bas.
